# EUROPEAN PATENT APPLICATION

(11) **EP 4 589 643 A1**
(43) Date of publication of application: **23.07.2025**
(21) Application number: 23865560.9
(22) Date of filing: 13.09.2023
(51) Int. Cl.: H01L 21/60, C22C 9/00, C22F 1/00, C22F 1/08

(54) **COPPER BONDING WIRE, METHOD FOR MANUFACTURING COPPER BONDING WIRE, AND SEMICONDUCTOR DEVICE**

(30) Priority: 16.09.2022 JP 2022148253
(71) Applicant: Tanaka Electronics Co., Ltd., Saga 842-0031 (JP)
(72) Inventor: MITOMA, Shuichi, Kanzaki-gun, Saga 842-0031 (JP); NAKASHIMA, Shinichiro, Kanzaki-gun, Saga 842-0031 (JP); YANAI, Hirofumi, Kanzaki-gun, Saga 842-0031 (JP)
(74) Representative: Plougmann Vingtoft a/s
(86) International application number: PCT/JP2023/033354
(87) International publication number: WO 2024/058211

(57) **Abstract**

Provided is a copper bonding wire that can improve cuttability, bonding strength, and conformability, and that prevents lift-off of the wire and wire detachment from a tool. A copper bonding wire is a copper wire made of a copper alloy having a copper purity of 99.99 mass % or more, and is configured such that: a density of crystal grain boundary in a cross section perpendicular to a wire axis of the copper wire is 0.01 µm⁻¹ or more and less than 0.6 µm⁻¹; among crystal orientations in a wire axis direction in the cross section, a value obtained by dividing an orientation ratio of a crystal orientation <111> having an angular difference of 15° or less relative to the wire axis direction by an orientation ratio of a crystal orientation <101> having an angular difference of 15° or less relative to the wire axis direction is 10 or more and 650 or less; a dynamic hardness is 45 or more and 90 or less; and an elastic modulus in the cross section is 20 GPa or more and 70 GPa or less.

## Description

### Technical Field

The present invention relates to a copper bonding wire (hereinafter, referred to as "copper wire"), and in particular to a copper bonding wire suitable for an application involving a large current, such as connecting power semiconductors together, or connecting a lithium-ion battery module bus bar to a lithium-ion battery electrode in an electric vehicle, a method for manufacturing the same, and a semiconductor device using the copper wire.

In general, "semiconductor" is a general term for a CPU (Central Processing Unit), a memory, and the like, which mainly function in "calculation," "storage," and the like. For example, a semiconductor is used in a consumer device such as a personal computer, a smartphone, or a television set. On the other hand, a power semiconductor has a role in supplying power to drive a motor, charge a battery, and operate a microcomputer and an LSI (large-scale integrated circuit). The power semiconductor is primarily used to change a voltage or frequency, to perform a power conversion (converting direct current to alternating current or alternating current to direct current), and the like. The power semiconductor is also referred to as a power device, a power element, a power semiconductor element, or the like.

An "inverter" installed in an energy-saving home appliance such as an air conditioner, a refrigerator, or a washing machine is a familiar example of the use of the power semiconductor. The inverter controls the motor rotation speed by converting the frequency. The inverter freely changes the motor rotation speed and by doing so can reduce unnecessary movement of the motor and contribute to energy conservation. On the other hand, an air conditioner without an inverter adjusts the room temperature by repeatedly turning the motor on and off, which can result in problems such as a lack of temperature stability and high power consumption. These functions of the inverter are achieved by a power semiconductor (power transistor) precisely "switching" the current on and off.

Besides the energy-saving home appliance, a power semiconductor is also widely used in, for example, the transportation sector including an electric vehicle, a hybrid vehicle, and the like. In the transportation sector, a power semiconductor such as an IGBT (insulated gate bipolar transistor) is used to convert and control the power. An IGBT includes bonding wires that connect IGBT chips (power chips) to each other and to an external electrode. A large current flows through the bonding wire for the power semiconductor, and thus a relatively thick aluminum wire with a wire diameter (diameter) of 40 µm or more and 700 µm or less is used.

As described above, a general semiconductor, whose main purpose is to perform calculation using a small power, and a power semiconductor, whose main purpose is to control the power itself generated by a large power, are considered completely different even though they are both semiconductors. A bonding wire used in the general semiconductor only carries a small current. For this reason, the bonding wire used in the general semiconductor is often a thin wire with a wire diameter of 30 µm or less, made of Au, Ag, or Cu. A bonding method involves melting one side of the wire to form a molten ball, which is bonded to a semiconductor chip electrode or the like by applying heat, ultrasonic waves, and pressure. In contrast, the bonding wire used in the power semiconductor needs to carry a large current. Thus, as described above, a thick aluminum wire that has a wire diameter of 40 µm or more, has relatively low electrical resistance, and is inexpensive is used. A bonding method for the bonding wire used in the power semiconductor does not create a molten ball, but applies ultrasonic waves and pressure to the wire at room temperature, thereby bonding the wire to an electrode or the like.

Also, unlike the general semiconductor, the power semiconductor repeatedly turns on and off a flow of a large current through the switching described above, and thus requires a bonding wire that can withstand the thermal load caused by heating and cooling. Furthermore, since the power semiconductor is used in applications that demand exceptional safety, such as in automobiles or trains, the power semiconductor needs to have high levels of durability and reliability. From the above, the characteristics, properties, and the like required for the bonding wire used in the general semiconductor and that required for the bonding wire used in the power semiconductor are completely different, even though they are both bonding wires.

In recent years, at the international conference (COP21) aimed at reducing greenhouse gas emissions as a measure against global warming and climate change, an international framework (the Paris Agreement) for reducing greenhouse gas emissions and the like after 2020 has been adopted, and the movement towards a decarbonized society is accelerating around the world. The automobile industry plays a major role in this agreement. European countries have announced policies to completely ban the sale of internal combustion engine vehicles (gasoline vehicles and diesel vehicles) by 2035 and limit the sale to electric vehicles (including plug-in hybrid vehicles). Furthermore, the United States has also set a goal of making electric vehicles 50% of the domestic new car market by 2030. This trend is also occurring in emerging countries such as China and India, and Japan also has a policy to switch all new vehicle sales to electric vehicles (including hybrid vehicles) by 2035.

As the shift to electric vehicles accelerates as described above, there are issues that hinder the widespread use of electric vehicles. Specifically, the driving range (the distance that can be traveled until the charge runs out when starting from a fully charged state) is short, and there are few charging facilities (locations).

In particular, improving the performance of the power semiconductor is essential for extending the driving range. An electric vehicle can run by converting the direct current from the battery, which is an energy source, into alternating current using an inverter, which is a power semiconductor, thereby driving a motor.

Until now, the power semiconductor has been made using silicon (Si). However, in recent years, the power semiconductor made using silicon carbide (SiC) has become available. A conventional Si power semiconductor experiences energy losses both during current application and during switching operations, such as turning on and off. All these electrical energy losses are released as heat (causing heat generation) from the inverter. A heat dissipation mechanism is required to prevent this heat generation, and the use of such a mechanism results in a reduction in the interior space of the electric vehicle, an increase in the vehicle weight, and a shortened driving range.

The application of the SiC power semiconductor to an electric vehicle can reduce energy losses both during current application and during switching operations, such as turning on and off. This effect allows a passive element such as a transformer, which benefits from an increased switching frequency (higher frequency), to be made smaller, making it possible to reduce the size and weight of the power semiconductor, such as the inverter. Furthermore, the heat dissipation mechanism can be simplified, making the entire electric vehicle more compact (lighter). Further, the highly efficient operation of the inverter can extend the driving range per charge.

Furthermore, the widespread existence of battery charging facilities is essential, as it is key to the widespread use of electric vehicles. Concurrently, there is a growing need for rapid charging. As a result, there is a demand for a bonding wire that can withstand the large current that occurs during rapid charging.

In the midst of this trend towards miniaturization and large current compatibility, most bonding wires in the power semiconductors today are made primarily using aluminum. In addition to the power semiconductor, the aluminum bonding wire is used as a wire connecting a lithium-ion battery module bus bar to a lithium-ion battery electrode in the electric vehicle. Aluminum has high thermal resistance and electrical resistance, and thus it generates a large amount of heat during current application but has a low heat dissipation effect. Thus, adoption of the aluminum wire goes against the trend toward miniaturization of the power semiconductor. Furthermore, a phenomenon has been reported that, in a bonding portion of the aluminum wire having weak strength, heat generated by a large current passing through the wire causes grain coarsening, resulting in the bonding portion being damaged.

Therefore, the copper wire has been attracting attention as an alternative material to the aluminum wire. The copper wire has lower thermal resistance and electrical resistance than the aluminum wire, which helps prevent heat generation. The copper wire also has a high recrystallization temperature and can thus withstand a large current.

Meanwhile, a semiconductor using gallium nitride (GaN), known as a wide-gap semiconductor, is being increasingly used not only in the electric vehicle industry but also in an AC adapter used to charge a smartphone, a laptop, and the like. The use of the wide-gap semiconductor has made it possible to downsize a device to about half the conventional size, achieving ultra-compact size.

Furthermore, the role of the power semiconductor is becoming important in the recently popular IoT (Internet of Things) and the like. As an IoT-equipped home appliance becomes smaller, thinner, and denser every year, the power semiconductor becomes smaller, thinner, and denser, and the bonding space between the power chip and the bonding wire becomes narrower. For this reason, bonding of the bonding wire requires an efficient use of limited space.

As described above, the copper wire generates less heat than the aluminum wire and can withstand high outputs. However, copper is harder and has a higher elastic modulus than aluminum, these characteristics being a major barrier to the ultra-miniaturization of the power semiconductor.

For example, bonding of the bonding wire and the power chip (first bonding) and bonding of the bonding wire and the external electrode (second bonding) are generally performed substantially in a straight line in the same direction. However, as the power semiconductor becomes increasingly miniaturized, the second bonding needs to be made in a tiny gap around the electrode, and, for bonding, the wire must be bent at a sharp angle by adding sharp bends and twists to the wire. For this reason, the bonding wire needs some degree of freedom to bend so that the wire direction (angle) can be changed during the bonding operation. In other words, flexible conformability is a very important property for the bonding wire for miniaturizing the power semiconductor. Furthermore, similar problems also exist in so-called reverse wire bonding, in which the first bonding is at the external electrode side and the second bonding is at the power chip side. In this regard, the elastic modulus of the copper wire is higher than that of the aluminum wire, and thus the conformability of the copper wire is very poor. Thus, the possibility of the copper wire detaching from a wedge tool is higher than that of the aluminum wire.

As described above, the inventors have discovered that if the wire connecting the first bonding and the second bonding is forced to twist or bend sharply, this adversely affects cuttability for cutting the wire. That is, when the wire is sharply bent or the like, the wire is deformed, even if only slightly, and a cutter cannot reach the wire well and cannot cut the wire completely, resulting in so-called incomplete cutting. If an incomplete cutting occurs, the wire detaches (lifts off) from the bonding portion before the wire is torn off, or, although the wire does not lift off, the wire cannot be cut at a height lower than or equal to the height set on the bonder, causing the height limit to be activated and the device to stop.

To summarize the above, a shift to electric vehicles is essential to reduce greenhouse gas emissions, and as the key to widespread use of electric vehicles, (A) extending the driving range and (B) increasing production of rapid charging facilities are urgently needed. Regarding (A), a reduction in the weight of the automobile is necessary, and such a reduction requires miniaturization and high heat dissipation of the power semiconductor. Thus, there is a growing need for a copper bonding wire with low electrical resistance and thermal resistance. Regarding (B), it is essential to adopt a copper bonding wire that can withstand a large current and high output. As described above, the copper bonding wire for the power semiconductor, which is becoming increasingly miniaturized, has the problem of "low conformability," and furthermore, the limited bondability poses problems in the "cuttability" and "bonding strength" of the wire. The ultimate mission of the present invention is to simultaneously solve these three wire problems.

Patent Literature 1 describes that an object of the invention is to provide a copper bonding wire with improved storage life in the atmosphere and that the storage life can be improved by using a copper bonding wire for semiconductor device having a density of crystal grain boundary on the surface of 0.6 (µm/µm²) or more and 1.6 (µm/µm²) or less. However, there is no mention of issues regarding the cuttability and conformability of the wire.

Patent Literature 2 describes a problem in which the mounting process using a copper bonding wire in mass production requires special bonding conditions due to low bondability and describes that this problem, which is a reason widespread practical use of the copper bonding wire has been delayed, can be solved by setting the total percentage of Cu, Cu₂O, CuO, and Cu(OH)₂, on the wire surface, measured by X-ray photoelectron spectroscopy to 10%, and setting Cu[II]/Cu[I], which is a ratio of the total percentage (Cu[II]) of CuO and Cu(OH)₂ corresponding to Cu having a valence of two relative to the percentage (Cu[I]) of Cu₂O corresponding to Cu having a valence of one in a range of 0.8 to 12. However, there is no mention of issues regarding the cuttability and conformability of the wire. Furthermore, Patent Literature 2 is an invention of a bonding wire with a small wire diameter for a high-density mounting semiconductor device, this bonding wire having a different application from that of a bonding wire with a large wire diameter for a power semiconductor, and the characteristics and properties required of the wires are also different.

Patent Literature 3 describes that an object of the invention is to provide a Cu alloy bonding wire for a semiconductor device, which can satisfy the performance requirements for a high-density LSI application, and that the problem can be solved by having each abundance ratio, on an average area basis, of a crystal orientation <100>, a crystal orientation <110>, and a crystal orientation <111>, which have an angular difference of 15 degrees or less relative to the direction perpendicular to a plane including the central axis of the wire, of 3% or more and less than 27%, among the crystal orientations on the wire surface. However, there is no mention of improving the cuttability and bonding strength and preventing the wire detachment from a tool. Furthermore, the invention described in Patent Literature 3, like Patent Literature 2, is an invention related to a bonding wire with a small wire diameter for a high-density LSI application, and such a bonding wire is essentially different from a bonding wire for a power semiconductor application.

### Citation List

### Patent Literature

PTL 1: International Publication No. 2021/111908
PTL 2: International Publication No. 2021/167083
PTL 3: International Publication 2020/059856

### Summary of Invention

### Technical Problem

The present invention has been made to solve the above-mentioned problems, and has an object to provide a copper bonding wire (hereinafter also referred to as "copper wire") that can improve cuttability and bonding strength and prevent wire detachment from a tool in wire bonding for connecting, for example, power semiconductors to each other, and a lithium-ion battery module bus bar and a lithium-ion battery electrode.

Another object of the present invention is to provide a method for manufacturing a copper wire that can improve cuttability and bonding strength and prevent wire detachment from a tool in wire bonding related to, for example, a connection between power semiconductors and the above-mentioned connection between a battery module bus bar and a battery electrode, and also provide a semiconductor device using the copper wire.

### Solution to Problem

As a result of extensive studies, the present inventors have found that a copper wire of the following embodiment, and a copper wire and a semiconductor device produced by a production method of the following embodiment can simultaneously solve the problems of cuttability, bonding strength, and detachment of a copper wire from a tool in wire bonding.

A copper bonding wire of an embodiment is made of a copper alloy having a copper purity of 99.99 mass % or more, and is configured such that: a density of crystal grain boundary in a cross section perpendicular to a wire axis of the copper bonding wire is 0.01 µm⁻¹ or more and less than 0.6 µm⁻¹; among crystal orientations in a wire axis direction in the cross section, a value obtained by dividing an orientation ratio of a crystal orientation <111> having an angular difference of 15° or less relative to a wire axis direction by an orientation ratio of a crystal orientation <101> having an angular difference of 15° or less relative to the wire axis direction is 10 or more and 650 or less; a dynamic hardness in the cross section is 45 or more and 90 or less; and an elastic modulus in the cross section is 20 GPa or more and 70 GPa or less.

The copper alloy preferably includes, relative to the total amount thereof, silver (Ag) in an amount of 5 mass ppm or more and 30 mass ppm or less, and phosphorus (P), iron (Fe), silicon (Si), arsenic (As), and antimony (Sb) each in an amount of 0 mass ppm or more and 3 mass ppm or less with the total amount being 15 mass ppm or less.

Furthermore, it is preferable that the wire diameter of the copper wire of the embodiment be 40 µm or more and 700 µm or less.

Further, a method for manufacturing a copper wire of an embodiment is a method for manufacturing a copper bonding wire made of a copper alloy having a copper purity of 99.99 mass % or more, the method including:
a step of preparing a copper wire made of a copper alloy having a copper purity of 99.99 mass % or more;
a step of drawing the copper wire; and
a step of performing a final heat treatment on the drawn copper wire to produce the copper bonding wire, the copper bonding wire being configured such that:
   a density of crystal grain boundary in a cross section perpendicular to a wire axis of the copper bonding wire is 0.01 µm⁻¹ or more and less than 0.6 µm⁻¹;
   among crystal orientations in a wire axis direction in the cross section, a value obtained by dividing an orientation ratio of a crystal orientation <111> having an angular difference of 15° or less relative to a wire axis direction by an orientation ratio of a crystal orientation <101> having an angular difference of 15° or less relative to the wire axis direction is 10 or more and 650 or less;
   a dynamic hardness in the cross section is 45 or more and 90 or less; and
   an elastic modulus in the cross section is 20 GPa or more and 70 GPa or less.

A semiconductor device of an embodiment is a power semiconductor device including at least one substrate, at least one semiconductor element on the substrate, an electrode on a surface of the semiconductor element, a semiconductor element upper substrate on the semiconductor element, at least one circuit pattern on the substrate, and
a copper wire connecting one or more selected from the group consisting of the electrodes on the surface of the semiconductor element, the electrode on the surface of the semiconductor element and an external electrode, the electrode on the surface of the semiconductor element and one of the circuit patterns, the electrode on the surface of the semiconductor element and a terminal, two adjacent circuit patterns among the circuit patterns, one of the circuit patterns and the terminal, the substrates, and the semiconductor element upper substrate on the semiconductor element and the circuit pattern, wherein:
the copper wire is a copper bonding wire made of a copper alloy having a copper purity of 99.99 mass % or more; and the copper bonding wire is configured such that: a density of crystal grain boundary in a cross section perpendicular to a wire axis of the copper bonding wire is 0.01 µm⁻¹ or more and less than 0.6 µm⁻¹; among crystal orientations in a wire axis direction in the cross section, a value obtained by dividing an orientation ratio of a crystal orientation <111> having an angular difference of 15° or less relative to a wire axis direction by an orientation ratio of a crystal orientation <101> having an angular difference of 15° or less relative to the wire axis direction is 10 or more and 650 or less; a dynamic hardness in the cross section is 45 or more and 90 or less; and an elastic modulus in the cross section is 20 GPa or more and 70 GPa or less.

Note that, in the present specification, the term "x to y" indicates a range of numerical values from a value x to a value of y.

### Advantageous Effects of Invention

The copper bonding wire of the present invention can improve the cuttability and bonding strength in the wire bonding and prevent wire detachment from a tool.

The method for manufacturing the copper bonding wire of the present invention can obtain the copper wire that can improve the cuttability and bonding strength and prevent wire detachment from a tool in the wire bonding related to, for example, the connection between the power semiconductors, and the connection between the bus bar used in the battery mobile and the battery electrode.

The semiconductor device using the copper wire of the present invention can obtain long-term stable bonding without having detachment (lift-off) at the wire bonding portion, and achieve further long-term reliability of the bonding (first bonding and second bonding) because the good conformability of the copper wire prevents defects in the wedge bonding.

### Brief Description of Drawing

[FIG.1] FIG. 1 is a cross-sectional view showing a schematic configuration of a semiconductor device according to an embodiment.
[FIG. 2] FIG. 2 is a cross-sectional view showing a schematic configuration of a semiconductor device according to another embodiment.
[FIG. 3] FIG. 3 is a cross-sectional view showing a schematic configuration of a semiconductor device according to yet another embodiment.
[FIG. 4] FIG. 4 is a photograph showing a trace of a bonding wire detaching from a first bonding portion in a sample product, where bonding portion detachment (lift-off) has occurred.
[FIG. 5] FIG. 5 is a photograph showing a trace of the bonding wire detaching from a second bonding portion in the sample product, where bonding portion detachment (lift-off) has occurred.
[FIG. 6] FIG. 6 is a photograph showing a state of a bonder when incomplete cutting of a wire occurs after second bonding.
[FIG. 7] FIG. 7 is a photograph of a transverse section of a copper wire of an embodiment with a density of crystal grain boundary of 0.18 µm⁻¹.
[FIG. 8] FIG. 8 is a photograph of a transverse section of a copper wire with a density of crystal grain boundary of 0.68 µm⁻¹.
[FIG. 9] FIG. 9 is a photograph of a wire not detaching from a tool.
[FIG. 10] FIG. 10 is a photograph of a wire detaching from the tool.
[FIG. 11] FIG. 11 is a schematic diagram showing a structure of a bond head and a state immediately after wire bonding in a front cut method.
[FIG. 12] FIG. 12 is a schematic diagram showing a structure of a bond head and a state immediately after the wire bonding in a rear cut method.
[FIG. 13] FIG. 13 is a diagram schematically showing a part of a lithium-ion battery module.
[FIG. 14] FIG. 14 is a diagram schematically showing a part of a lithium-ion battery module of another aspect.
[FIG. 15] FIG. 15 is a diagram schematically showing the entire lithium-ion battery module.

### Description of Embodiments

Hereinafter, a copper bonding wire according to an embodiment of the present invention will be described. The copper wire of the present embodiment is suitably used for connecting power semiconductors to each other, and connecting a bus bar of the battery mobile and a battery electrode. The copper wire of the present embodiment is made of a copper alloy having a copper purity of 99.99 mass % or more, a density of crystal grain boundary in a cross section of the copper wire perpendicular to a wire axis thereof is 0.01 µm⁻¹ or less than 0.6 µm⁻¹; among crystal orientations in a wire axis direction in the cross section, a value obtained by dividing an orientation ratio of a crystal orientation <111> having an angular difference of 15° or less relative to the wire axis direction by an orientation ratio of a crystal orientation <101> having an angular difference of 15° or less relative to the wire axis direction is 10 or more and 650 or less; a dynamic hardness in the cross section is 45 or more and 90 or less; and an elastic modulus in the cross section is 20 GPa or more and 70 GPa or less. The details of trial and error up to the completion of the present invention and the configuration and manufacturing method of the copper wire of the present embodiment will be described below.

Examples of the wire cut error include detachment (lift-off) of the wire from bonding portions between the wire and a substrate or the like before the wire itself is cut. The lift-off occurs because the bonding strength of the wire is weaker than its rupture strength. As a factor that greatly affects the lift-off, in addition to the cuttability, the weakness of the bonding strength itself at the bonding portion between the wire and the substrate or the like can be mentioned. A method of improving the bonding strength will be described later.

First, the present inventors carefully observed a large number of sample products, which had been manufactured under various manufacturing conditions, about the relationship between the cuttability of the copper wire and the metallographic structure of the cross section perpendicular to the wire axis. As a result, they have found that there is a correlation between the density of crystal grain boundary and the cuttability. Hereinafter, a cross section perpendicular to the wire axis of a copper wire is also referred to as a "transverse section."

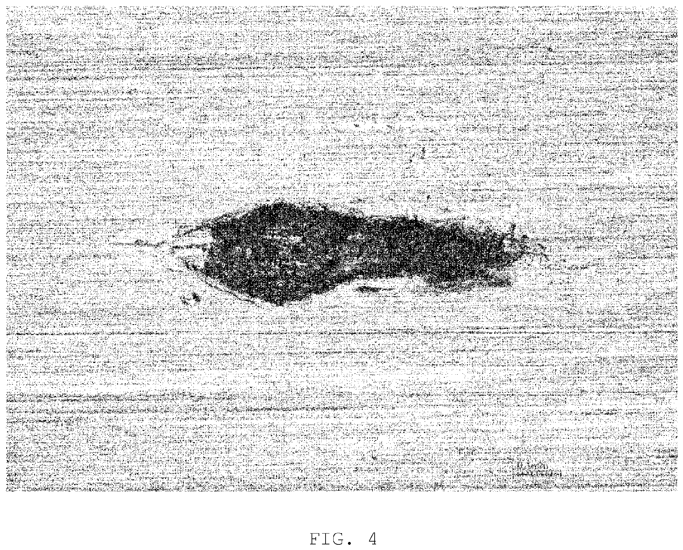

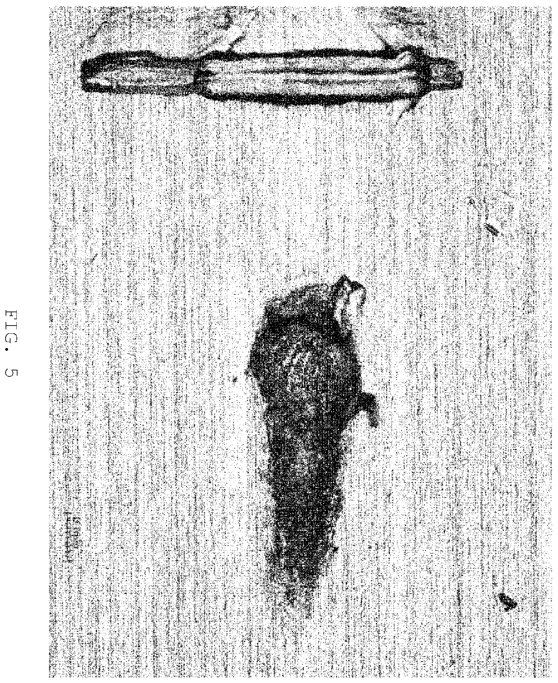

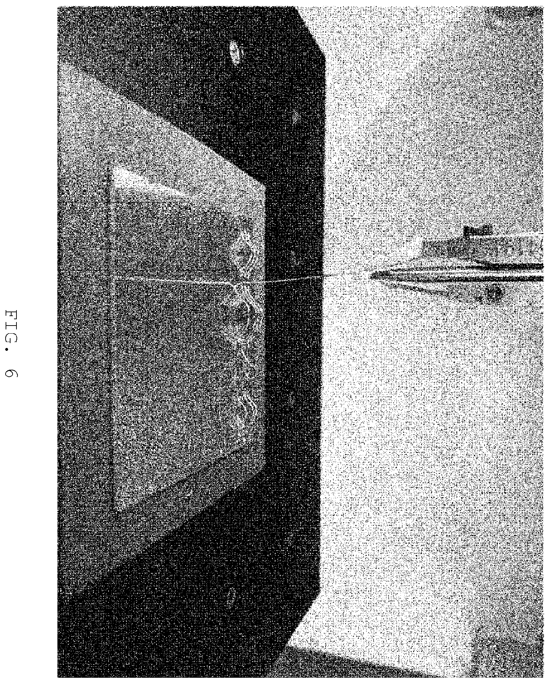

Specifically, to evaluate the continuous bonding properties of the many sample products described above, continuous bonding was performed with a wire bonding device. Then, the sample products were categorized into two types: those that completed bonding without interruption until the end and those where bonding was stopped halfway through. The cause of the stoppage during continuous bonding with the sample products where bonding was stopped halfway was examined in detail, and it was found that the stoppage was categorized into two causes: stoppage due to bonding-portion detachment (lift-off) and stoppage caused when the wire was pulled to a set height and attempted to be torn off but stopped without being cut (stoppage due to exceeding the height limit). FIG. 4 is a photograph showing a trace of a bonding wire detaching from a first bonding portion in a sample product, where bonding portion detachment (lift-off) has occurred. FIG. 5 is a photograph showing a trace of the bonding wire detaching from a second bonding portion in the sample product, where bonding portion detachment (lift-off) has occurred. Incidentally, in FIG. 5, a scar with a predetermined width in the longitudinal direction of the paper surface is a scar produced by a blade of a cutter. When the wire is cut by a front cut method (full cut method), there is a possibility of damaging the bonding object when the object is made of a delicate material. FIG. 6 is a photograph showing a state of a bonder when incomplete cutting of a wire occurs after second bonding. From the state of FIG. 6, it is considered that the bonder would be stopped due to exceeding the height limit.

The inventors carefully observed the crystal structure of the cross section of each sample product wire that had been subjected to the continuous bonding test. They finally noticed that the density of crystal grain boundary affected the cuttability of the wire, and thus had a significant impact on the continuous bonding properties. That is, the inventors have clarified that if the density of crystal grain boundary (= length of crystal grain boundary (µm) / area of wire cross section (µm²)) is 0.01 µm⁻¹ or more and less than 0.6 µm⁻¹, the wire bonding device tends to perform continuous bonding without interruption until the end; if the density of crystal grain boundary is less than 0.01 µm⁻¹, the wire stretches too far before being cut and the wire bonding device tends to stop because of exceeding the height limit; and if the density of crystal grain boundary is 0.6 µm⁻¹ or more, the wire bonding device tends to stop because of detachment (lift-off) from the bonding portion before the wire is cut.

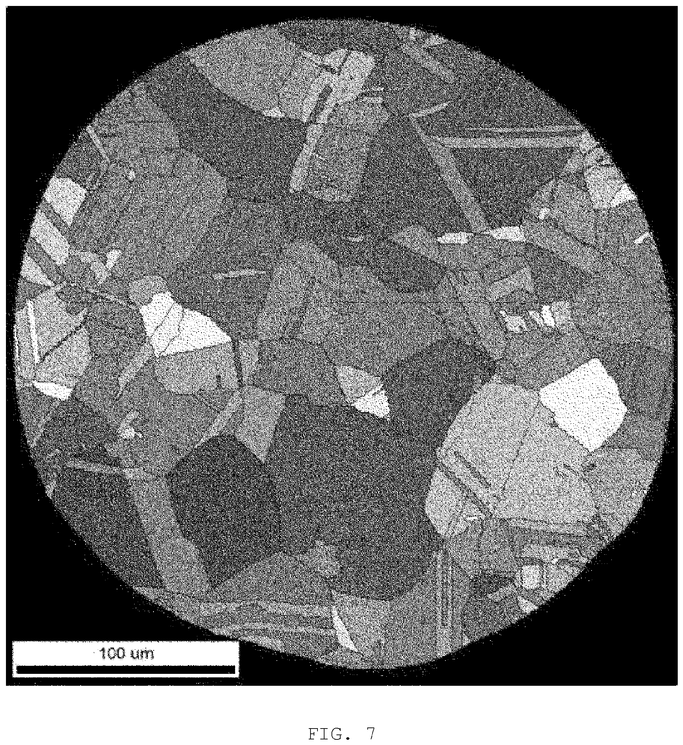

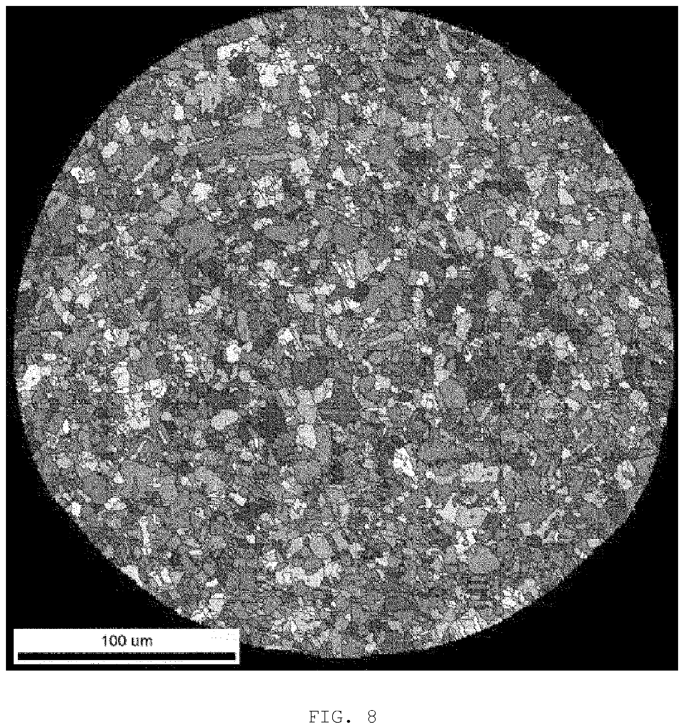

In general, the smaller the crystal grain size is, the longer the total length of the crystal grain boundary tends to be, and the larger the crystal grain size is, the shorter the total length of the crystal grain boundary tends to be. However, the individual crystal grain shapes are of great variety, and the total length of the grain boundary varies depending on the crystal grain shape even if the crystal grain sizes are substantially the same. For example, in the case of a polygonal crystal grain, even if the crystal grain size is substantially the same, the length of the grain boundary greatly differs depending on the number of corners of the polygon. Therefore, the inventors have devised that it is more suitable to use the density of crystal grain boundary as an index than the crystal grain size in order to investigate the relationship with the cuttability. FIG. 7 is a photograph of a transverse section of a copper wire of the embodiment with a density of crystal grain boundary of 0.18 µm⁻¹, and FIG. 8 is a photograph of a transverse section of a copper wire with a density of crystal grain boundary of 0.68 µm⁻¹.

The length of the crystal grain boundary varies depending on the wire diameter. Basically, the thicker the wire is, the longer the crystal grain boundary is, and the thinner the wire is, the shorter the crystal grain boundary is. Therefore, the present invention adopts a value of a density of crystal grain boundary obtained by dividing the total length of crystal grain boundary (µm) by the area of the cross section perpendicular to the longitudinal direction of the wire (µm²). A measuring method of a density of crystal grain boundary will be described later.

In the copper bonding wire of the present embodiment, the density of crystal grain boundary in the transverse section of the wire is 0.01 µm⁻¹ or more and less than 0.6 µm⁻¹. This density can improve the cuttability of the copper wire. The density of crystal grain boundary is more preferably 0.03 µm⁻¹ or more and 0.5 µm⁻¹ or less, and even more preferably 0.05 µm⁻¹ or more and 0.3 µm⁻¹ or less.

Although the relationship between the cuttability and the density of crystal grain boundary, as well as the details of the mechanism, remain unknown, it is presumed that crack propagation tends to concentrate on specific crystal grain boundaries where the density of crystal grain boundary is smaller in the tear-off after the crack is formed in the wire, and this contributes to the ease of cutting the wire.

Next, a bonding strength will be described. Aluminum has been used as the bonding wire of power semiconductors, but the copper wire is harder than the aluminum wire and harder to crush. Therefore, the bonding area of the bonding portion tends to be small in wedge bonding, leading to a decrease in the bonding strength. When the wire is forcibly deformed by applying a large load during bonding in order to increase the bonding area, there is a high risk of damage if the object to be bonded is a delicate object, such as semiconductor chips.

The easier the copper wire is deformed, the more easily the copper wire is crushed. Consequently, the bonding area can be increased even with a small load. This, in turn, enhances the bonding strength while also preventing damage to the chip. As a result of examining the index of the crushability, the inventors have concluded that the dynamic hardness considering the elastic characteristics of the wire is the optimum index.

Vickers hardness (Hv) and Knoop hardness (HK), which are widely used for measuring the hardness of metal materials, are determined by a method where an indenter is brought into contact with a sample surface to apply a test force thereto, thereby forming a dent, and a diagonal length of the dent after removing the force is used to calculate the surface area thereof. However, the characteristics reflecting the elasticity of the material cannot be evaluated with this method. In considering the bonding operation process in which the wire is actually held by a wedge tool and ultrasonic waves are applied for bonding in a state where the elastic deformation is applied, it is considered that the above-mentioned hardness values are not suitable as an index showing the wire characteristics.

The Vickers hardness is the most commonly used index of hardness and is a method of evaluating hardness by pressing a material with a diamond indenter and measuring the resulting indentation (area) left on the material. In the Vickers hardness, because the indenter that has pressed the material is pulled up, the pushed-in material recovers slightly because of its elastic properties. Therefore, the area of the indentation formed by the indenter becomes slightly smaller, and so the hardness value measured is slightly larger than the actual value.

The dynamic hardness is defined as a value obtained from a test force and an indentation depth in the process of pushing the indenter, and it can reflect not only the plasticity of the sample but also the return deformation due to its elasticity. An operation in which the wedge tool grabs the wire and then crushes and deforms the wire and a series of operations of the dynamic hardness measurement are very similar to each other. Thus, the inventors considered that it would be very suitable as a value representing the characteristics of the copper wire of the embodiment. In addition, since the dynamic hardness is measured in a state where the indenter remains pressed into the material, the effect of the elastic recovery of the material is eliminated. Therefore, the inventors have thought that the dynamic hardness is an optimum evaluation method for representing the characteristics of a material having a high elastic modulus, such as a copper wire, in particular.

In addition, when the dynamic hardness is measured, the elastic modulus of the wire can also be measured by applying and releasing the test force. The inventors considered that the elastic modulus is also an important parameter reflecting the ease of crushing and conformability of the wire, and therefore included it in the evaluation items.

The present inventors measured the dynamic hardness and the elastic modulus of many sample products produced by different manufacturing methods, and as a result, found that when the dynamic hardness in the transverse section of the copper wire is 45 or more and 90 or less and the elastic modulus in the transverse section of the copper wire is 20 GPa or more and 70 GPa or less, the wire is crushed with a small load without causing a defect, so that the bonding area of the bonding portion can be widened and the insufficient bonding strength can be solved.

The dynamic hardness (DH) of the copper wire of the present embodiment is more preferably 50 or more and 80 or less, and even more preferably 55 or more and 70 or less. When the dynamic hardness is less than 45, the bonding area of the crushed wire becomes too large, causing contact with adjacent wires and increasing the risk of a short-circuit failure. When it exceeds 90, the strength of the wire becomes too high to allow crushing. As a result, the bonding area cannot be increased, and the object to be bonded, such as a semiconductor chip, may also be damaged.

The elastic modulus in the transverse section of the copper wire of the present embodiment is more preferably 30 GPa or more and 60 GPa or less, and even more preferably 35 GPa or more and 50 GPa or less. When the elastic modulus is less than 20 GPa, there is a high possibility that a so-called leaning failure occurs in which the wire bonded from the first bonding portion to the second bonding portion crushes. When the elastic modulus exceeds 70 GPa, there is a high possibility that the wire detaches from the wedge tool described later. The dynamic hardness and the elastic modulus are preferably measured in a cross section perpendicular to the wire longitudinal direction, in particular, in a region closer to the outer circumference than the midpoint of the radius.

Dynamic hardness and elastic modulus can be measured, for example, by attaching a triangular pyramid indenter having a crest-to-crest angle of 115° to a micro-compression tester MCT-W500 manufactured by Shimadzu Corporation, under the following conditions.
Test mode: Load-unload test
Test force: 980.665 mN
Loading rate: 20.7411 mN/sec
Holding time: 10 seconds

Bonding strength was measured as follows. Using a bonder BJ935 manufactured by HESSE GmbH, a wire was bonded to a copper plate with dimensions of length 50 mm × width 50 mm × thickness 1 mm was subjected to a pull test. Bonding was performed under conditions of a load of 2,500 gf and a Power of 50 V, and the bonding portion lift-off rate was compared between 20 (n = 20) sample product wires when the center of the loop was subjected to a pull test. When the number of lift-off occurrences was 3 or more in 20 times (n = 20) pull test, it was judged as failing. When it was less than 3 times, it was judged as acceptable.

Next, a further problem with the bonding wire accompanying the miniaturization of the power semiconductor will be described. In general, when a sufficient space for wire bonding can be ensured, the bonding operation can be performed linearly, and the loop curve of the wire is not complicated at all. However, when the bonding area is limited, since the required wires should be bonded within a limited area, the loop curve becomes complicated, and furthermore, the bonding operation involves sudden bending and torsional bonding. For example, in the first bonding (connection to the electrode on a semiconductor chip) and the second bonding (connection to the lead frame or the external electrode on a substrate) of the copper wire, a wedge tool (sometimes simply referred to as a "tool") having an alligator clip (groove portion) for clipping the wire at its tip is employed, and bonding is performed by clipping the wire to the alligator clip and pressing the wire against the bonding portion. In bonding operations that involve a lot of bending and twisting, the wire held by the wedge tool (clamp) may fail to follow the movement and may detach from the alligator clip of the tool. Copper wires with a higher elastic modulus (springiness) than the conventionally used aluminum wires are predominantly prone to detachment from a tool.

If the second bonding is performed while part of the wire detaches from the wedge tool, adequate bonding property cannot be ensured, potentially causing the bonding portion to detach in a certain environment, leading to failure. Furthermore, if the bonding operation is performed in a state where the wire detaches from the tool during the second bonding on the chip, the tip of the wedge tool may be brought into direct contact with the metal film portion on the element, leading to breakage of the semiconductor element.

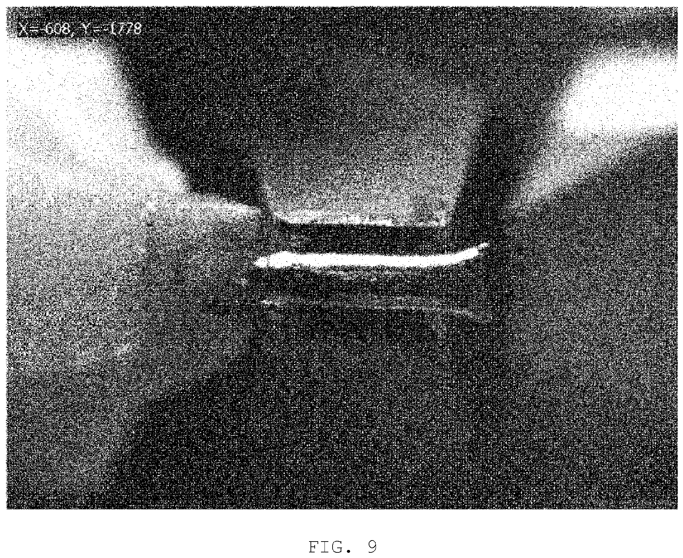

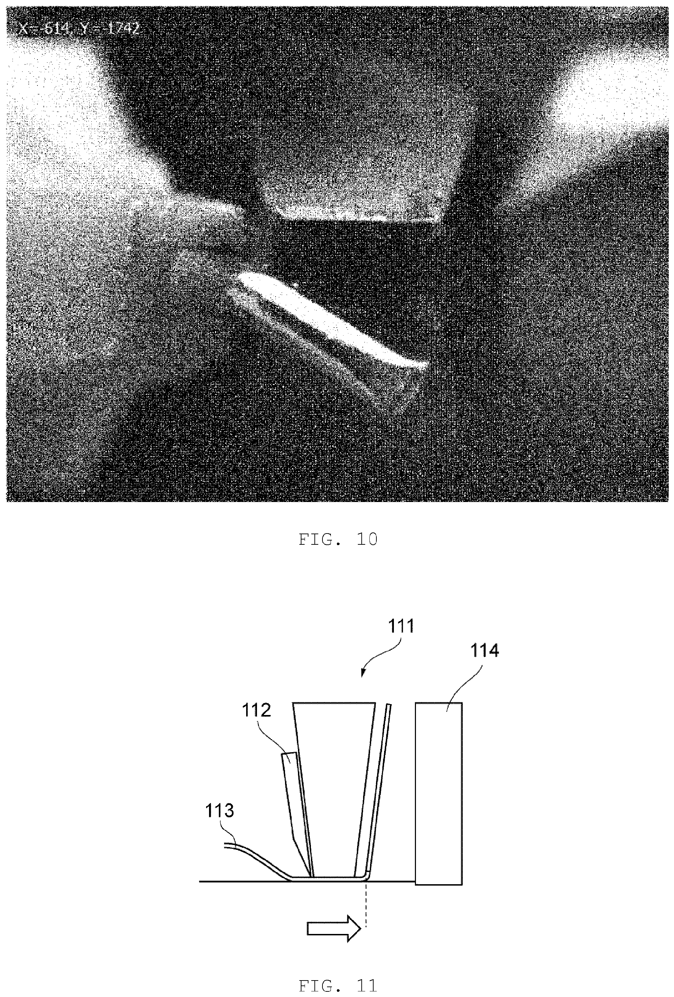

By controlling the elastic modulus in the transverse section of the copper wire to 20 GPa or more and 70 GPa or less, detachment from a tool has been largely eliminated. However, the present inventors have intensively studied for the purpose of solving the detachment from a tool in a more sophisticated manner, and found that the problem of the detachment from a tool can almost be solved by controlling, in addition to the elastic modulus, the value obtained by dividing an orientation ratio of the crystal orientation <111> having an angular difference of 15° or less relative to a wire axis direction by an orientation ratio of the crystal orientation <101> having an angular difference of 15° or less relative to the wire axis direction among the crystal orientations in the wire axis direction in the cross section perpendicular to the wire axis to 10 or more and 650 or less. FIG. 9 is a photograph of a wire not detaching from a tool. In the photograph of FIG. 9, a wire is fitted to an alligator clip. FIG. 10 is a photograph of a wire that detaches from the tool. In the photograph of FIG. 10, a wire is detached from the alligator clip.

Specifically, the inventors have found that controlling the value obtained by dividing an orientation ratio of the crystal orientation <111> having an angular difference of 15° or less relative to the wire axis direction by an orientation ratio of the crystal orientation <101> having an angular difference of 15° or less relative to the wire axis direction at the same point under the same conditions among crystal orientations in the wire axis direction in the transverse section in a direction perpendicular to the wire axis (hereinafter, also referred to as "ratio of crystal orientation ratios") to 10 or more and 650 or less effectively prevents most detachment from a tool. The ratio of crystal orientation ratios in the transverse section in a direction perpendicular to the wire axis is more preferably 20 or more and 500 or less, and even more preferably 30 or more and 450 or less. When the ratio of crystal orientation ratios is less than 10, detachment from a tool is less likely to occur. When it exceeds 650, detachment from a tool does not occur. However, there is an increased possibility that a defect other than detachment from a tool, such as not being able to be successfully cut, will occur. The ratio of crystal orientation ratios can be calculated by the following equation. Ratio of crystal orientation ratios = (orientation ratio of crystal orientation <111>) / (orientation ratio of crystal orientation <101>)

The mechanism that the ratio of crystal orientation ratios in the transverse section in a direction perpendicular to the wire axis being 10 or more and 650 or less is effective in preventing the detachment from a tool is not clear. However, the crystal orientation <111> is the orientation of the sliding surface in the wire processing, and it is presumed that the larger the crystal orientation ratio is, the more flexibly the wire can respond to sudden movements of a tool. The inventors also have succeeded in finding that the conformability of the wire to the movement of the tool can be improved by determining the ratio of the crystal orientation <111> to the crystal orientation <101> that is not the crystal orientation of the sliding surface. Incidentally, the ratio of crystal orientation ratios of the crystal orientation <111> to the crystal orientation <100> was also examined, but there was no significant characteristic tendency.

Meanwhile, copper is easily oxidized, and when a copper oxide film is formed on the surface of a copper wire, the bonding strength becomes low.

Furthermore, as described above, the copper wire of the present invention has a wire diameter of 40 µm to 700 µm, which is thicker than that of a wire (wire diameter of 15 µm to 30 µm) used in a general semiconductor device, and the bonding area (volume) is also large, so that a large current can flow at a larger voltage than that of a thin wire. However, when the electrical resistance of the copper wire itself is high, the current becomes small even at the same voltage, and the advantage of the wire thickness is impaired. When the electrical conductivity of ultra-high purity copper with a purity of 99.999 mass% and less impurity is defined as 100%, the present inventors aimed to ensure an electrical conductivity of at least 99% also for the copper wire of the present embodiment, which contains more impurities (copper wire of a purity of 99.99 mass% or more) as a value relative to 100% of the electrical conductivity of the ultra-high purity copper as assumed.

As described above, the widespread use of electric vehicles is expected as one of global warming countermeasures (reduction of carbon dioxide emission). However, in order to promote the widespread use of electric vehicles, it is desired to solve the problem of the electric vehicles that the travel distance (driving range) at full charge is shorter than that of a gasoline vehicle. In order to extend the travel distance of an electric vehicle, miniaturization (weight reduction) of the electric vehicle is an important object. On the other hand, the larger the energy loss generated by the electrical resistance of a copper wire during the switching (on-off) of a power semiconductor and the heat emission associated therewith, the more space is required for cooling. As a result, the electric vehicle becomes larger in size. One of the obstacles to the miniaturization of automobiles is the electrical resistance of this copper wire, in other words, reducing the electrical resistance of the wire is an crucial factor in promoting the widespread use of electric vehicles.

The present inventors studied to simultaneously solve the problem of oxide formation on the wire surface and the problem of increase in electrical resistance by adjusting the chemical composition of a wire made of a copper alloy. The inventors explored alloying elements that effectively suppress the progression of oxide formation and prevent an increase in electrical resistance in copper with a purity of 99.99%. The present inventors conducted extensive studies and experiments by adding a large number of elements to a copper base material, and have found that addition of silver (Ag) and control of the contents of, in particular, phosphorus (P), iron (Fe), silicon (Si), arsenic (As), and antimony (Sb) can suppress copper oxide formation and also an increase in electrical resistance.

As a result of conducting many experiments, the present inventors have found that silver (Ag) is preferably 5 mass ppm or more and 30 mass ppm or less relative to the total amount of the copper alloy. Furthermore, they have found that phosphorus (P), iron (Fe), silicon (Si), arsenic (As) and antimony (Sb) may not be contained, but the content of each element is preferably adjusted to 3 mass ppm or less, and the total amount of phosphorus (P), iron (Fe), silicon (Si), arsenic (As), and antimony (Sb) is preferably 15 mass ppm or less relative to the total amount of the copper wire.

The present inventors have found that when the content of silver (Ag) is 5 mass ppm or more and 30 mass ppm or less relative to the total amount of the copper alloy, and at the same time, when the content of each element of phosphorus (P), iron (Fe), silicon (Si), arsenic (As), and antimony (Sb) is 0 mass ppm or more and 3 mass ppm or less and the total amount thereof is 15 mass ppm or less, it is easy to obtain the effect of delaying the formation of copper oxide, and the electrical resistance of the entire copper wire does not increase excessively.

In particular, in the manufacturing process of the copper wire of the present embodiment, when the copper wire is exposed to a high temperature during the heat treatment, depending on the state of the heat treatment atmosphere, the formation rate of copper oxide is increased. In this case, the copper wire that has been controlled to the above-described chemical composition exhibits an effect of delaying the formation rate of copper oxide.

The progress state of oxidation on the surface of a copper wire can be evaluated by measuring the oxide film of copper(II) oxide (CuO) formed on the surface of the copper wire after the copper wire storage test. The storage test is conducted by placing a copper wire sample in a container or the like, which is not hermetically sealed, and leaving it at room temperature of 35°C and a humidity of 75%RH for up to 10 months. During this test period, the CuO oxide film formed on the copper ribbon's surface is measured after 1 hour and then every month thereafter, i.e., at 1 month, 2 months, 3 months, and so on, up to 10 months. In the progression process of copper oxidation, copper(I) oxide (Cu₂O) is first formed, and as the oxidation proceeds, the ratio of CuO increases. Therefore, by calculating the ratio of CuO oxide film, it is possible to evaluate the ease of oxide formation on the copper wire surface (oxidation resistance). The larger the ratio of CuO oxide film, the more the oxidation proceeds. The ratio of CuO oxide film can be calculated by the following equation. Ratio of CuO oxide film = ((CuO oxide film) / (CuO oxide film + Cu2O oxide film)) × 100 (%)

In the present embodiment, in particular, the ratio of CuO oxide film after 6 months is used as an evaluation standard, and if the ratio of the oxide film of copper(II) oxide (CuO) is 30% or less, it is rated as pass "A," and if it is 20% or less, it is rated as better "S." An analysis method therefor will be described later.

As the electric conductivity, IACS (International Annealed Copper Standard) was adopted. As compared to IACS (100%) of cupper with a purity of 99.999 mass %, a sample with IACS decreased by a reduction rate of less than 0.5% is evaluated as superior and assigned a rating of "S." A sample with IACS decreased by a reduction rate of greater than 0.5% and less than 1% is evaluated as good and assigned a rating of "A." A measuring method for IACS will be described later.

The wire diameter of the copper wire of the present embodiment is usually 40 µm or more and 700 µm or less, preferably 70 µm or more and 600 µm or less, and more preferably 100 µ m or more and 500 µm or less.

### (Manufacturing method of copper wire)

Next, an example of a manufacturing method of the copper wire according to the embodiment will be described. Note that the manufacturing method of the copper wire is not limited to the following manufacturing method. In addition, it is desirable to appropriately adjust the conditions in view of the weight of the copper wire to be manufactured and the processing capacity of a heat treatment furnace.

High purity copper of 99.99 mass % or more is melted together with silver according to the chemical composition of the copper wire to prepare a copper melt. For the melting, a heating furnace such as an arc heating furnace, a high-frequency heating furnace, a resistance heating furnace, or a continuous casting furnace is used. Although there is no problem in atmospheric melting, for the purpose of preventing contamination of air in the atmosphere, the copper melt in the heating furnace is preferably melted by holding it in vacuum or an inert gas atmosphere of such as argon, nitrogen, or the like. The melted material is solidified by continuous casting so as to have a predetermined wire diameter (diameter) from the heating furnace to produce a wire. Alternatively, the molten copper may be cast into a mold to form an ingot, and the ingot may be set in an extruder and extruded to form a wire with a predetermined wire diameter. Alternatively, a rough drawing wire may be manufactured by a DIP forming method or an SCR method and used as a wire.

The wire obtained in the above-described step is drawn into an intermediate wire material having a wire diameter of 900 µm. Then, the intermediate wire material is subjected to an intermediate heat treatment for heating at 400°C to 600°C for 60 minutes to 420 minutes. The intermediate heat treatment may be performed in a "combustion furnace" using petroleum, gas, or the like as a heat source or an "electric furnace" using electric energy as a heat source, and using a "batch type" or "continuous type" process. Furthermore, the treatment may be of an "energization type" in which the wire is heated by direct energization. The heat treatment atmosphere is preferably an inert gas atmosphere from the viewpoint of preventing oxidation of the wire.

Next, wire drawing is performed to obtain a final wire diameter that is targeted for the wire that has been subjected to the intermediate heat treatment. In the wire drawing, a wire is sequentially passed through a plurality of cemented carbide dice or diamond dice, so that the wire diameter thereof is stepwisely reduced. It is desirable that the wire reduction rate (also referred to as area reduction rate and processing rate) before and after performing die drawing once be 5% or more and 30% or less.

As a finishing process, a heat treatment (final heat treatment) is performed on the wire processed to the final wire diameter. Final heat treatment conditions are the most important part for manufacturing the copper wire of the embodiment. As a result of trial and error in various heat treatment experiments, the present inventors have found that the following method is most preferable in the manufacturing process of the copper wire of the embodiment. For the final heat treatment, an energization heating type treatment was adopted. The conditions of the energization heating include a voltage value of 16 V or more and 28 V or less, a distance between electrode terminals of 800 mm or more and 1,300 mm or less, a wire travel speed of 50 m/min or more and 200 m/min or less, and use of the second electrode immersed in cooling water (this means that the wire moves into the cooling water while being heated). Pure water is used as the coolant, and the temperature of pure water is 20°C or higher and 80°C or lower, and the test is carried out with a dissolved oxygen concentration in pure water of 8 mg/liters or less. In order to prevent the wire oxidation, the area between the electrode terminals through which the wire passes is covered with a cylindrical shaped object, and nitrogen gas is allowed to flow at a flow rate of 30 liters/minute or more and 60 liters/minute or less. Although the energization heating type treatment has been described here, other heat treatment types may be adopted as long as the heating conditions are the same.

### (Semiconductor device)

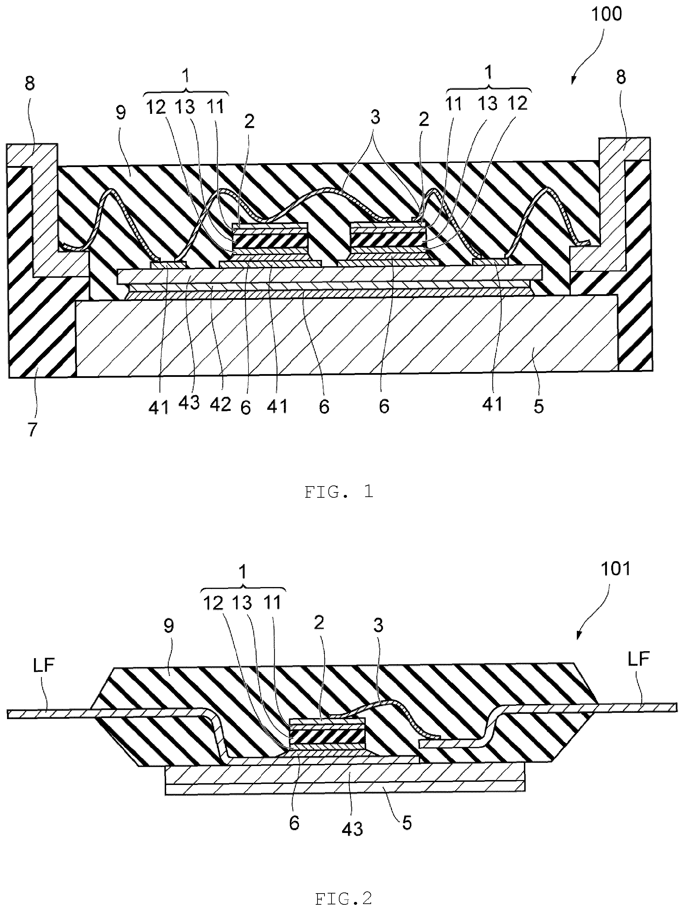

Next, a configuration of a semiconductor device 100 using the copper wire of the embodiment will be described with reference to FIG. 1.

As illustrated in FIG. 1, the semiconductor device 100 includes semiconductor elements 1, metal films 2, wires 3, circuit patterns 41, a metal pattern 42, an insulating member 43, a heat dissipation member 5, bonding materials 6, a case 7, terminals 8, and a sealing material 9.

In the present embodiment, the semiconductor element 1 is, for example, a power semiconductor used in a semiconductor for power supply. Examples of the semiconductor element 1 include a metal oxide semiconductor field effect transistor (MOSFET; Metal Oxide Semiconductor Field Effect Transistor) and an insulated gate bipolar transistor (IGBT; Insulated Gate Bipolar Transistor).

The semiconductor element 1 formed by stacking an electrode 11, a substrate portion 13, and a back electrode 12 in this order. The electrode 11 is, for example, an aluminum (Al) - silicon (Si) electrode, and the substrate portion 13 is, for example, a silicon (Si) substrate, a silicon carbide (SiC) substrate, a gallium nitride (GaN) substrate, or the like.

The metal film 2 is provided on a surface of the electrode 11 opposite to the substrate portion 13 so as to cover the surface of the electrode 11. The metal film 2, which is a nickel (Ni) film, a copper (Cu) film, a titanium (Ti) film, a tungsten (W) film, or the like, is formed by electroplating, electroless plating, vapor deposition, sputtering, or the like. Examples of the nickel (Ni) film include a nickel (Ni) electroless plating film, and specifically, an electroless nickel (Ni)-phosphorus (P) plating film and an electroless nickel (Ni)-boron (B) plating film. Other preferred aspects of the metal film 2 will be described later.

The wire 3 is composed of the copper wire of the embodiment described above, and the configuration and characteristics thereof are also as described above. The wire 3 is bonded to the surface of the metal film 2.

Next, other configurations of the semiconductor device 100 will be described. In the semiconductor device 100, a semiconductor circuit is formed by the semiconductor elements 1, the wires 3, the terminals 8, the circuit patterns 41, and the metal pattern 42. The wires 3 are bent in the semiconductor device 100, and are bonded to the semiconductor elements 1, the terminals 8, the circuit patterns 41, and the like by using the bent portions.

In the semiconductor device 100, the bonding material 6, the metal pattern 42, the insulating member 43, the circuit patterns 41, the bonding material 6, and the semiconductor elements 1 are sequentially stacked on the surface of the heat dissipation member 5 in this order. The bonding material 6 is made of solder, silver (Ag), or the like that bonds between the heat dissipation member 5 and the metal pattern 42, and between the circuit pattern 41 and the back electrodes 12 of the semiconductor devices 1. The insulating member 43 is an insulating substrate or the like.

The case 7 is formed of an annular housing having a space therein, and is provided so as to surround the outer periphery of the heat dissipation member 5. The semiconductor elements 1, the metal films 2, the wires 3, the circuit patterns 41, the metal patterns 42, the insulating member 43, the bonding materials 6, and the sealing material 9 are accommodated in the internal space of the case 7.

The terminals 8 function as a connection terminal with an external device. The terminals 8 are provided on the upper surface of the case 7, and are arranged such that one end thereof protrudes from the case 7 in the internal space of the case 7 and the other end thereof protrudes from the case 7 to the outer region of the case 7. The sealing material 9 fills the internal space of the case 7 to encapsulate the semiconductor elements 1, the metal films 2, the wires 3, the circuit patterns 41, the metal patterns 42, the insulating member 43, and the bonding materials 6. The sealing material 9 is a cured product of a gel-like sealing resin, a mold resin, or the like.

The semiconductor device 100 shown in FIG. 1 may include electrodes 11 on the plurality of semiconductor elements 1, a plurality of circuit patterns 41, and a plurality of terminals 8. The semiconductor device 100 preferably has an electrode-circuit pattern bonding structure including one electrode 11 out of the multiple semiconductor elements 1, one circuit pattern 41 out of the multiple circuit patterns 41, and a wire 3 that connects the electrode 11 and the circuit pattern 41. Furthermore, the semiconductor device 100 preferably has an electrode-terminal connection structure including one terminal 8 out of the multiple terminals 8, one electrode 11 out of the multiple electrodes 11, and a wire 3 that connects the terminal 8 and the electrode 11. In addition, the semiconductor device 100 preferably has a circuit pattern-terminal connection structure including one terminal 8 out of the multiple terminals 8, one circuit pattern 41 out of the multiple circuit patterns 41, and a wire 3 that connects the terminal 8 and the circuit pattern 41. The semiconductor device 100 includes one or more electrode-circuit pattern bonding structures, one or more electrode-terminal connection structures, and one or more circuit pattern-terminal connection structures, and preferably includes two or more electrode-circuit pattern bonding structures, two or more electrode-terminal connection structures, and two or more circuit pattern-terminal connection structures. That is, the copper wire of the embodiment can be used for connection between the electrode 11 and the circuit pattern 41, for connection between the terminal 8 and the electrode 11, or for connection between the terminal 8 and the circuit pattern 41.

The semiconductor device 100 may further include a substrate (semiconductor element upper substrate) on the semiconductor element 1, and in this case, the semiconductor device 100 preferably has a bonding structure including the semiconductor element upper substrate, the circuit pattern 41, and the wire 3 that connects the semiconductor element upper substrate and the circuit pattern 41. The same applies to semiconductor devices 101 and 103 described later.

FIG. 2 shows the semiconductor device 101 having a lead frame as another embodiment of the semiconductor device. In FIG. 2, components having the same functions as those of the semiconductor device 100 shown in FIG. 1 are denoted by the same reference numerals, and detailed descriptions thereof will be omitted. The semiconductor device 101 shown in FIG. 2 has a lead frame LF in addition to the semiconductor element 1, the metal film 2, the wire 3, the insulating member 43, the bonding material 6, and the sealing material 9. The semiconductor device 101 shown in FIG. 2 does not include the case 7 because it has the lead frame LF, but may include the case 7. The lead frame LF is bonded to the surface of the insulating member 43 and has the same function as that of the circuit pattern 41 of the semiconductor device 100 shown in FIG. 1. In FIG. 2, the lead frame LF and the insulating member 43 are bonded to each other, but a metallic plate (not shown) may be disposed between the lead frame LF and the insulating member 43.

The sealing material 9 is provided so as to enclose the semiconductor element 1, the metal film 2, the wire 3, the insulating member 43, the bonding material 6, and the lead frame LF. However, the end portions of the lead frame LF protrude to the outside of the sealing material 9, so that the lead frame LF constitutes an electric circuit with the semiconductor element 1 and the wire 3, and the protruding end portions function as a terminal 8 for connecting to an external device of the semiconductor device 101.

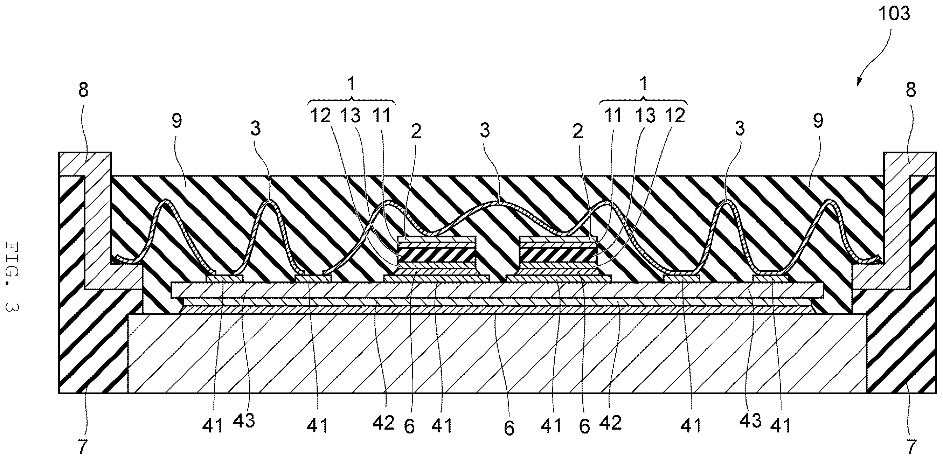

FIG. 3 schematically illustrates the semiconductor device 103 including circuit patterns 41 and wires 3 connecting the circuit patterns 41 as another embodiment of the semiconductor device. The semiconductor device 103 has another circuit pattern 41 adjacent to the circuit pattern 41 of the semiconductor device 100 shown in FIG. 1, and is different from the semiconductor device 100 in that the wires 3 are connected to the adjacent circuit patterns 41, but the other configurations are common. The semiconductor device 103 shown in FIG. 3 may have a plurality of circuit patterns 41, and includes a bonding structure including wires 3 connecting two adjacent circuit patterns among the multiple circuit patterns 41. The semiconductor device 103 includes one or more bonding structures, and preferably includes two or more bonding structures. That is, the copper wire of the embodiment can be used for connection between the circuit pattern 41 and the circuit pattern 41.

Next, a manufacturing method of the semiconductor device 100, the semiconductor device 101, and the semiconductor device 103 illustrated in FIGs. 1, 2, and 3 will be described. First, respective members constituting the semiconductor devices 100 and 101 are prepared, stacked according to the configurations described above, and bonded to each other. After that, the end portion of the wire 3 is bonded to the surface of the metal film 2 by ultrasonic bonding or the like. After that, the other end of the wire 3 is wedge-bonded to the external electrode (terminal 8 in FIG. 1 or LF in FIG. 2). As the wire 3, the copper wire of the embodiment described above is used. After that, a sealing resin is poured into the semiconductor device 100 and cured to form the sealing material 9. In the case of the semiconductor device 101, a lead frame on which the semiconductor element 1 and the like are mounted is placed in a mold, and a sealing resin is poured therein and cured to form the sealing material 9.

In the semiconductor device on which the copper wire of the embodiment described above is mounted, since detachment (lift-off) at the wire bonding portion does not occur, the bonding of the bonding portion 31 can be stably maintained for a long period of time. Furthermore, the good conformability of the copper wire enables the manufacture of semiconductor devices with long-term reliable bonding (the first bonding and the second bonding) in combination with the fact that the defects in the wedge bonding do not occur.

### [Examples]

Examples will be described below. The present invention is not limited to the following examples.

Copper wires of Examples were produced by the following method and conditions. Copper with a purity of 99.99 mass % or more and silver as an additive element are melted together. For melting, a continuous casting furnace (heating furnace) was used. For the purpose of preventing contamination of oxygen and the like from the atmosphere, after evacuating the copper melt in the heating furnace, the copper melt was melted by holding it in a nitrogen atmosphere. The melted material was solidified by continuous casting so as to have a predetermined diameter from the heating furnace to produce a wire.

The wire obtained as above was drawn into a wire with a diameter of 0.9 mm, and was subjected to an intermediate heat treatment for heating at 500°C for 120 minutes. After the intermediate heat treatment, the wire was drawn to obtain a final wire diameter of 0.5 mm (500 µm). The wire drawing was performed by using a plurality of cemented carbide dice or diamond dice so as to reduce the wire diameter stepwisely. The area reduction rate before and after one wire drawing process was controlled to fall within the range of 5 to 30%.

The wire processed to the final wire diameter was put into the energization heating furnace and subjected to a final heat treatment. The conditions of the energization heating included a voltage value of 16 V or more and 28 V or less, a distance between electrode terminals of 800 mm or more and 1,300 mm or less, a wire travel speed of 50 m/min or more and 200 m/min or less, and use of the second electrode immersed in cooling water. As a result, the wire was immersed in the cooling water while being heated. Pure water was used as the coolant, and energization heating was performed with the pure water at a temperature of 20°C or higher and 80°C or lower and a dissolved oxygen concentration in pure water of 8 mg/liters or less. The periphery of the electrode portion through which the wire passed was maintained in a nitrogen atmosphere. The conditions were varied within the above-mentioned ranges to obtain samples of Examples 1 to 30. After the final heat treatment, the wire was wound onto several spools, each containing approximately 200 meters of wire. The purity of copper and some of the contained elements of the copper wires of each example are shown in Table 2.

Table 2 shows the purity of copper and some of the contained elements of the copper wire of Comparative Examples. Regarding the manufacturing method of the copper wires of Comparative Examples, a manufacturing method from melting to achieving the final wire diameter was performed under substantially the same conditions as that for the manufacturing method of the copper wire of Examples while all or part of the ranges of the energization heating conditions described above only for the final heat treatment conditions were set to values outside the ranges of the manufacturing conditions of Examples. As a result, the copper wires of Comparative Examples 1 to 10 were obtained.

Next, methods for measuring respective characteristics of the copper wires of Examples and Comparative Examples will be described.

### (Measurement of density of crystal grain boundary and ratio of crystal orientation ratios)

Crystal orientations of the cross section perpendicular to the wire axis direction (longitudinal direction of wire drawing) were measured as follows. The produced copper wire was cut to prepare a plurality of wire samples with a length of several centimeters. The wire sample was fixed straight and flat on an Ag-plated metal frame (metal plate) with careful attention paid to avoid deformation. After that, the wire sample fixed to the metal plate was put into a cylindrical mold so that the metal plate became the bottom surface of the cylinder, and a resin for embedding was poured into the mold. After that, a curing agent was added to cure the resin. Subsequently, the cured cylindrical resin containing the wire sample was roughly polished by a polisher so as to expose a cross section perpendicular to the longitudinal direction of the wire. The cut surface was then finished by final polishing, followed by ion milling to remove any residual strain on the polished surface, resulting in a smooth surface. The ion milling apparatus was finely adjusted so that the cut surface of the wire was perpendicular to the longitudinal direction of the wire.

The density of crystal grain boundary and the crystal orientation ratio of the copper wires of Examples and Comparative Examples were measured and calculated by an electron backscatter analysis (EBSD: Electron Backscattered Diffraction Pattern) method. Specifically, the wire sample was attached to the sample table of a field emission scanning electron microscope (FE-SEM: Field Emission Scanning Electron Microscope) equipped with an EBSD measuring device (OIM Data Collection manufactured by EDAX/TSL Co., Ltd.) so that the transverse section of the wire sample (i.e., the polished surface of the sample) was parallel to the sample table. Then, the settings were configured so that the boundary measured at an acceleration voltage of 15 kV, a distance between measurement points of 1.5 µm, a magnification of 170x, the orientation difference between the adjacent measurement points exceeding 15° was regarded as a grain boundary and if five or more pixels with an orientation difference of 15° or less were connected, they were recognized as a single crystal grain.

The density of crystal grain boundary was calculated as a density of crystal grain boundary (µm⁻¹) obtained by dividing a total length of grain boundaries (µm) by a cross-sectional area of an analysis area (µm²). Note that a tip peripheral portion, a rear end peripheral portion, and an intermediate portion of the wire of about 200 m were selected as the measurement points, and the densities of crystal grain boundary in cross-sections perpendicular to the longitudinal direction at these three points were measured. The average value of these was shown in Table 1.

Similarly, the ratio of crystal orientation ratios in the cross section of the wire described above was determined as a value obtained by dividing an orientation ratio of the crystal orientation <111> having an angular difference of 15° or less relative to the wire axis direction by an orientation ratio of the crystal orientation <101> having an angular difference of 15° or less relative to the wire axis direction at the same point under the same conditions among crystal orientations in the wire axis direction. In addition, measurement was performed at three points similar to that for the density of crystal grain boundary as the measurement points, and the average values thereof were shown in Table 1.

### (Method for measuring dynamic hardness and elastic modulus)

Dynamic hardness and elastic modulus were measured by attaching a triangular pyramid indenter having a crest-to-crest angle of 115° to a micro-compression tester MCT-W500 of Shimadzu Corporation under the following conditions.
Test mode: Load-unload test
Test force: 980.665 mN
Loading rate: 20.7411 mN/sec
Holding time: 10 seconds

The measurement sample was prepared by cutting the wire sampled after the final heat treatment into three portions, i.e., the tip end portion, the rear end portion, and the intermediate portion between the tip and rear ends of the wire each having a length of 200 m. The sample was embedded in a resin so that the transverse section perpendicular to the wire axis was exposed approximately perpendicular to the wire axis. After polishing, measurement was performed at four points near the midpoint of the radius of the wire cross section. Average values of the measured values at the total 12 points are shown in Table 1. The four straight lines connecting each of the four points and the wire center are in a positional relationship of 90 degrees, and the four points are arranged at substantially equal intervals. The dynamic hardness and the elastic modulus are measured by the above-described measuring device in a series of flows at substantially the same time, but the dynamic hardness is determined by a load of the indenter (depth in the depth direction), and the elastic modulus is a value determined by the return of the indented sample by unloading the indenter. Therefore, each of the values is an independent value corresponding to the material.

Next, a method of evaluating each of the samples of Examples and Comparative Examples will be described.

### (Cuttability evaluation method)

Using a bonder BJ935 manufactured by HESSE GmbH, the number of errors occurring in the machine (number of stoppages) was counted for evaluation when the wire was continuously bonded to a copper plate with dimensions of length 50 mm × width 50 mm × thickness 1 mm. Bonding conditions were configured with a load of 2,500 gf and a Power of 50 V. For each sample, a combination of a first bonding and a second bonding was regarded as n = 1 (1st set), and 1,000 sets (n = 1,000) were subjected to continuous bonding. If errors occurred three or more times (number of stoppages), the performance was evaluated as failing and assigned a rating of "X." If errors occurred two times, although there were points to be improved, it was evaluated to be unlikely to be practically problematic and assigned a rating of "B." If an error occurred once, it was evaluated as good and assigned a rating of "A." If no errors occurred, it was evaluated as superior and assigned a rating of "S." The results are shown in Table 1.

### (Bonding strength evaluation method)

Bonding strength was tested also using a bonder BJ935 manufactured by HESSE GmbH. The wire, which was bonded to a copper plate with dimensions of length 50 mm × width 50 mm × thickness 1 mm was subjected to a pull test. Bonding conditions were configured with a load of 2,500 gf and a Power of 50 V. For each sample, a combination of a first bonding and a second bonding was regarded as n = 1 (1st set), and 20 sets (n = 20) were subjected to the pull test at the center of a loop. The numbers of lift-off occurrences at the bonding portion were compared among the respective samples. In the pull test of the sample of n = 20, if the number of lift-off occurrences was 3 or more, the performance was evaluated as failing and assigned a rating of "X." If the number of lift-off occurrences was 2, although there were points to be improved, it was evaluated to be unlikely to be practically problematic and assigned a rating of "B." If the number of lift-off occurrences was 1, it was evaluated as good and assigned a rating of "A." If no lift-offs occurred, it was evaluated as superior and assigned a rating of "S." The results are shown in Table 1.

### (Method of evaluating detachment from tool)

An ultrasonic bonding device (a wire bonder ASTERION manufactured by Kulicke & Soffa Industries, Inc.) was used to bond each sample of copper wires having a wire diameter of 500 µm to a copper plate so that the distance between a first bonding and a second bonding became 5 mm. The portion for the second bonding was bent at a target angle of 45° horizontally with respect to the wire axis direction and bonded. The bonding conditions were set so that the ultrasonic energy and the pressing force were the optimum conditions for each sample. The bonding tool used was manufactured by Kulicke & Soffa Industries, Inc. and model number: 127595-20, and the dimensions of an alligator clip for clipping the wire were 0.5 mm for the opening (inner diameter), 0.2 mm for the thickness (height), and 1.0 mm for the length (depth).

The determination of whether detachment failure from the tool occurred was made by observing the state of the wire at the second bonding portion. In each sample, a combination of a first bonding and a second bonding was regarded as performing one time, and the test was performed 100 times. If the wire was not attached or the number of contact marks with the tool where the tool was hit at one side was 4 or more, the performance was evaluated as failing and assigned a rating of "X." If the number of contact marks with the tool was 2 or 3, although there were some points to be improved, it was evaluated to be practically problematic and assigned a rating of "B." If the number of contact marks with the tool was 1, it was evaluated as being good and assigned a rating of "A." If there were no contact marks, it was evaluated as superior and assigned a rating of "S." The results are shown in Table 1.

In addition, copper wires of Examples 31 to 111 and Comparative Examples 11 to 30 were obtained in the same manner as that in Example 1 and that in Comparative Example 2 described above, except that the chemical compositions and the manufacturing conditions were each changed, and were evaluated in the same manner as that in Example 1. The results are shown in Tables 4 to 6.

### (Comprehensive evaluation)

If one or more "S" ratings were present in the three evaluations in Tables 1 and 4 to 6 above, and the remaining evaluations were either rated as "S" or "A," the comprehensive evaluation was rated as superior and assigned a rating of "Superior." If the total number of "A" and "S" ratings was two or more, the comprehensive evaluation was rated as good and assigned a rating of "Good." If there were two or more "B" ratings and no "X," the comprehensive evaluation was rated as a passing grade and assigned a rating of "Acceptable." If a sample received even one "X" rating, the comprehensive evaluation was rated as failing and assigned a rating of "Failing." These results are shown in Table 1.

Specific combinations (regardless of the order) of the respective evaluations are as follows:
"Superior ": SSS, SSA, SAA
"Good": SAB, SSB, AAB, AAA
"Acceptable": SBB, ABB, BBB,
"Failing": a case where a sample received even one X.

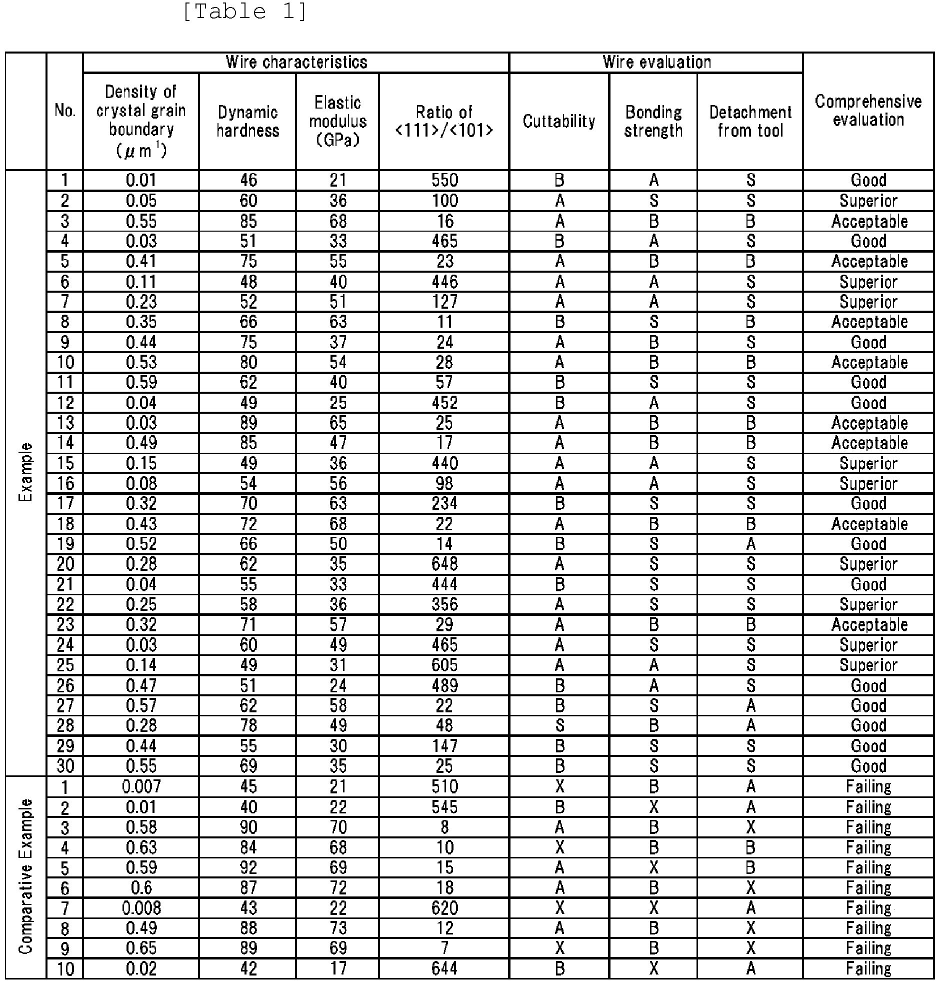

Table 2 shows the purity of copper and the concentration (content ratio) of part of the contained elements of Examples and Comparative Examples. The respective concentrations were calculated by an inductively coupled plasma-mass spectrometer (Inductively Coupled Plasma-mass spectrometry, ICP-MS) (8800ICP-MS manufactured by Agilent Technologies Japan, Ltd.) owned by Tanaka Denshi Kogyo K.K., which is the applicant.

Next, the samples of Examples and Comparative Examples were left to stand at room temperature of 35°C and a humidity of 75%RH for 6 months. After that, the oxidation state of the copper wire surface was analyzed. When Ag concentration was 5 ppm or more, the ratio of the oxide film of copper(II) oxide (i.e., CuO) of the sample was 20% or less. In the process of copper oxidation, copper(I) oxide (i.e., Cu₂O) is usually formed first, and as the oxidation proceeds, the ratio of CuO increases. Therefore, by calculating the ratio of CuO oxide film, it is possible to evaluate the ease of oxidation formation of the copper wire (oxidation resistance). The ratio of CuO oxide film was determined by converting "(CuO oxide film) / (CuO oxide film + Cu₂O oxide film)" into a percentage.

The oxide film was measured by sequential electrochemical reduction analysis (SERA: Sequential Electrochemical Reduction Analysis), and the thickness equivalent value determined by SERA was used. SERA analysis for determining the thickness of copper(II) oxide (CuO) and that of copper(I) oxide (Cu₂O) described above can be performed using a QC-200 manufactured by ECI Technology, for example, in the following manner. The wire with a diameter of 0.5 mm is sandwiched between two O-rings and the area of the diameter of 2.1 cm is separated with a gasket, and a borate buffer is poured therein and saturated with nitrogen. A current density (I) of 150 µA/cm² is applied to the above-mentioned area, and the time (seconds) (t) required for Cu₂O reduction reaction appearing in -0.30 V to -0.60 V and CuO reduction reaction appearing in -0.60 V to -0.85 V is measured. The thickness T (nm) of each of CuO and Cu₂O is calculated based on T = K·I·t using a constant K obtained from Faraday's law. Note that the value of the constant K for CuO is 6.53 × 10⁻⁵ (cm³/A·sec) and the value of K for Cu₂O is 2.45 × 10⁻⁴ (cm³/A·sec).

Measurement was performed on the surface of the wire at three points including a tip peripheral portion, a rear peripheral portion, and an intermediate portion of the wire, and the average value thereof was determined. A sample having a CuO oxide film ratio of 20% or less was evaluated as superior and assigned a rating of "S," and a sample having a ratio of more than 20% and 30% or less was evaluated as good and assigned a rating of "A."

Here, the reason the ratio of the CuO oxide film being 30% or less is determined to be good will be described. In power modules, IGBTs, MOSFETs or diode chips are mounted on a substrate in which a ceramic plate (silicon nitride, alumina, or the like) and a copper plate are bonded and integrated by an active metal bonding method (Active Metal Brazing: AMB) or a direct bonding method (Direct Copper Bonding: DCB), and a circuit is formed on the substrate by wire bonding.

For example, in a copper wire bonded on a copper plate of a DCB substrate, a problematic thermal expansion and shrinkage of the silicone resin may cause a force to be applied to the wire bonding portions in a temperature cycle test (for example, -65°C to 150°C) performed on a finished product which is sealed with the silicone resin and, as a result, the wire may detach. The temperature conditions of the temperature cycle test are determined by universal automotive standards. The present inventors considered that the growth of the oxide film on the copper wire surface by heat is one of the main causes of the detachment. Then, they have found that after the storage test of the copper wire, i.e., after 6-month storage at room temperature of 35°C and a humidity of 75%RH, if the ratio of the CuO film on the copper wire surface was 30% or less, the detachment of the bonding portion of the wire was able to be greatly reduced in the above-mentioned temperature cycle test.

Furthermore, in recent years, an operation guarantee temperature range of power semiconductors has become wider, and for example, a guarantee in a range of -65°C to 175°C has been demanded. In these temperature cycle tests, a higher load is applied to the copper wire than the test conditions described above, and so the wire detaching from the bonding portion is likely to occur. The present inventors have found that when the ratio of the CuO oxide film on the wire surface is controlled to 20% or less during the above-described storage test, it becomes possible to meet such high performance demands and prevent the wire detachment from the bonding portion even under more severe conditions, resulting in stable bonding strength obtained.

Furthermore, in addition to the problem of wire detachment due to the formation of the copper oxide film, the present inventors have found that the problem of deterioration in electric conductivity at high temperatures can occur due to the expansion of the guaranteed temperature range. That is, the electric conductivity tends to decrease as the temperature increases. As described above, since the wire diameter of the copper wire of the embodiment is thicker than the wire diameter of the bonding wire for general semiconductors, there is an advantage that a large current can flow therethrough at a high voltage. However, when the electrical resistance increases due to the temperature increase and the electric conductivity decreases, the current value decreases and the driving power may decrease.

Therefore, in manufacturing a power semiconductor device, it is necessary to quantitatively predict an increase in electrical resistance of a copper bonding wire at a higher temperature. If the electrical resistance increases more than that predicted, not only a designed current value cannot be realized, but also peripheral members may be adversely affected by the heat generation of the wire caused by the increase in the electrical resistance. For example, there may be a serious problem that the sealing resin, which is a peripheral member, melts due to heat generation of the wire.

The present inventors repeatedly conducted extensive and diligent research and experiments on the rate of increase in electrical resistance of copper bonding wires and the associated heat generation particularly in the high-temperature range as the guaranteed temperature range is expanded. As a result, they have found that when the electric conductivity (IACS) at room temperature is 99% or more (preferably 99.5% or more), the rate of increase in electrical resistance remains within the range (approximately 1.7 times or less) typically assumed in the manufacturing of power semiconductor devices.

Furthermore, to suppress the increase in electrical resistance and reduce the ratio of CuO oxide film on the copper wire surface to less than 30%, the present inventors conducted repeated experiments to evaluate electrical resistance and formation of CuO oxide film by blending trace amounts of various elements into high-purity copper. As a result, they found that these two problems can be resolved simultaneously if the copper wire contains silver (Ag) in an amount of 5 mass ppm or more and 30 mass ppm or less with respect to the entire copper wire, and also contains phosphorus (P), iron (Fe), silicon (Si), arsenic (As), and antimony (Sb), each in an amount of 0 mass ppm or more and 3 mass ppm or less, with the total amount of these elements excluding silver being 15 mass ppm or less.

The electric conductivity was measured in the same area according to IACS (International Annealed Copper Standard) and averaged. IACS is a value determined by first measuring the electric resistivity of each wire in accordance with the four-terminal method with a potential lead wire distance of 100 mm and a DC current of 200 mA, and then expressing a ratio of the obtained electric resistivity with respect to the electric resistivity of the annealed standard soft copper at room temperature (20°C), which is 1.7241 × 10⁻² µΩm, as 100%. As compared to IACS of copper with a purity of 99.999 mass %, if IACS of a sample is decreased by a reduction rate of less than 0.5%, such a sample is evaluated as superior and assigned a rating of "S." If IACS is decreased by a reduction rate of greater than 0.5% and less than 1%, such a sample is evaluated as good and assigned a rating of "A." The results are shown in Table 2. Some comparative examples had the evaluation of "S" or "A." However, the evaluation was made while specifying the ratio of CuO oxide film and the reduction rate of IACS, and as shown in Table 1, the other evaluations are rated as "X." Thus, it is determined that the comprehensive evaluation was assigned a rating of "fail."

In addition, for the copper wires of Examples 31 to 111 and Comparative Examples 11 to 30 shown in Tables 4 to 6, the purity of copper and the amounts of trace elements were measured in the same manner as described above, and the ratio of CuO oxide film (CuO ratio) and IACS reduction rate were evaluated. The results are shown in Tables 7 to 9.

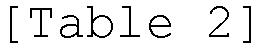

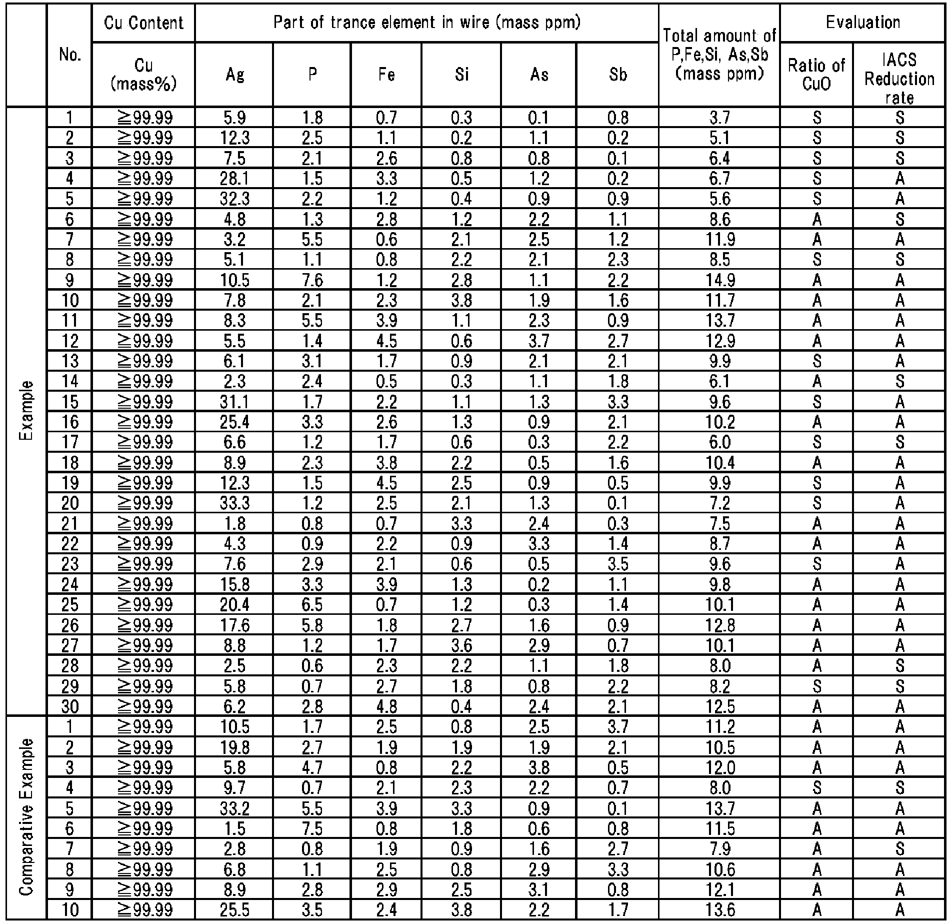

Cuttability evaluation was conducted on the same samples as those in Examples and Comparative Examples described in Table 1, to confirm whether equivalent cuttability could be achieved using the rear cut method (also known as the back cut method or half-cut method). Evaluation was performed in the same manner as in the "Cuttability evaluation method" described above, except that the wire was not cut completely (cut depth of about 50 to 70% with respect to the diameter of the vertical section in the longitudinal direction of the wire). The results are shown in Table 3.

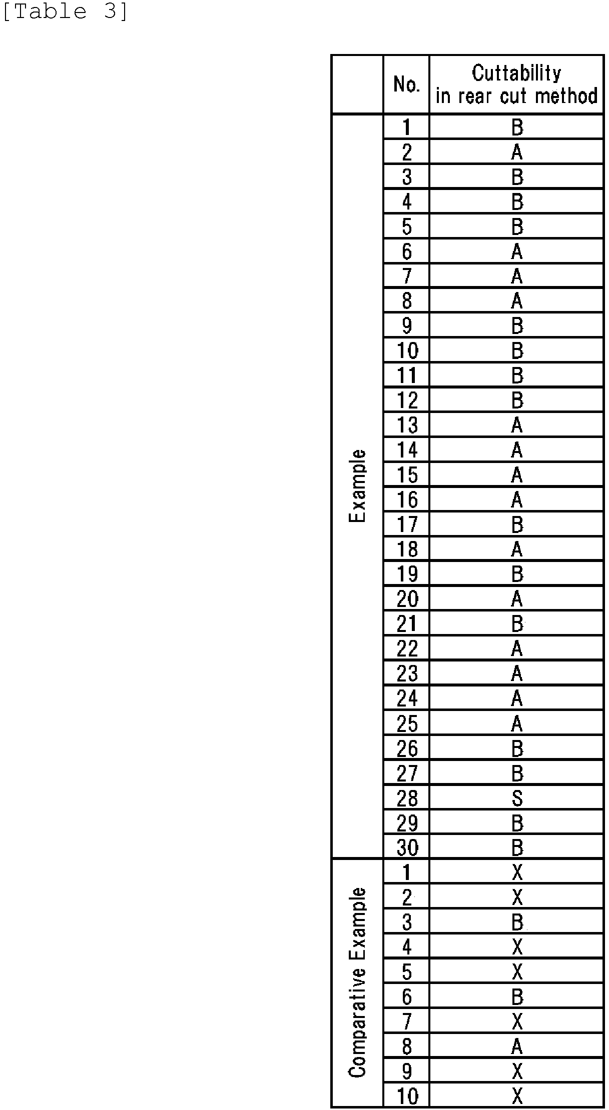

From the results of Table 3, although the evaluation of the cuttability of the wire samples evaluated using the rear cut method entirely becomes worse than that evaluated using the full cut method which is usually performed, the result of the passing level was obtained. From these results, it was confirmed that the copper wires of Examples was able to be used without problems even with the rear cut method. In some comparative examples, although the evaluations included "A," this was only an evaluation of the cuttability. As shown in Table 1, the evaluation items other than the cuttability were "X," it was also confirmed that the comprehensive evaluation became "Failing."

The front cut method (also referred to as a full cut method) and the rear cut method will be described. FIG. 11 is a schematic diagram showing a structure of a bond head 111 and the movement after a second bonding in the front cut method. The bond head 111 is a part of a bonder and includes a cutter and a bonding tool that grips a wire. In the case where the first bonding and the second bonding are performed in order, the bond head 111 moves the gripped wire in a direction from the first bonding to the second bonding where the bonder bonds the gripped wire to a bonding target. In the front-cut bonder, the cutter is provided in front of the bond head. Therefore, after the second bonding, the bond head (cutter) is moved to a position where the wire will be cut. That is, the bond head is moved in the direction indicated by the arrow in FIG. 11, and the wire is cut at that position. The distance from the position at the time of the second bonding to the cutting position of the wire, which may depend on the type of the bond head 111, is about 3 mm. Therefore, as shown in FIG. 11, if there is an obstacle such as a case 114 of a semiconductor device in the moving direction (arrow direction) of the bond head 111, and for example, if the distance from the bonding portion to the obstacle is equal to or less than 3 mm, there is a possibility that the bond head 111 collides with the case 114 and the bonder is stopped, or the semiconductor device is damaged.

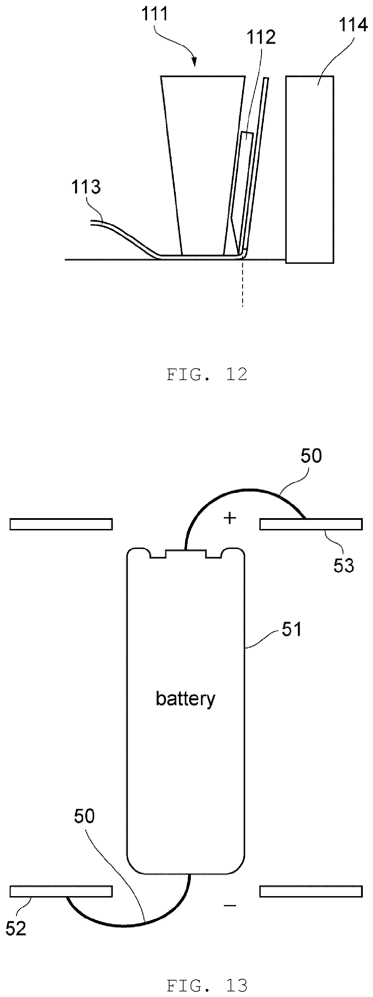

FIG. 12 is a schematic diagram showing a structure of a bond head and a state immediately after the wire bonding in the rear cut method. The movement of the bond head 111 in the process of forming the first bonding and the second bonding in the rear cut method is similar to that in the front cut method. However, since the position of the cutter 112 in the second bonding is substantially the same as the position where the wire 113 is cut, it is not necessary to move the bond head (cutter) during wire cutting. Therefore, even if an obstacle such as the case 114 of the semiconductor device is present at a short distance from the bonding portion, the possibility that the bond head comes into contact with the obstacle is much smaller than that in the front cut method. In the future, the expectation for the bonding method by the rear cut type is increasing as the semiconductor device is becoming increasingly miniaturized.

In reverse bonding (where the normal bonding involves a first bonding by which a copper wire is bonded to an IC chip followed by a second bonding by which the wire is bonded to an external electrode and a circuit pattern on a substrate, whereas the reverse bonding involves a first bonding by which a copper wire is bonded to an external electrode and a circuit pattern followed by a second bonding by which the copper wire is bonded onto an IC chip), the second bonding, immediately before the wire cutting, is performed on the IC chip. Thus, in the front cut method, also known as the full cut method, the cutter blade may come into contact with the IC chip, which is particularly susceptible to damage, potentially resulting in damage to the IC chip. Thus, the reverse bonding preferably employs the rear cut method, also known as the half cut method, where the wire is not completely cut but is cut to approximately 50% of its depth, followed by tearing it off along the cut line. Therefore, it was confirmed that the bonding wire of the present embodiment, which was excellent in the cuttability, exhibited the effect of the cuttability not only in the front cut method but also in the rear cut method.

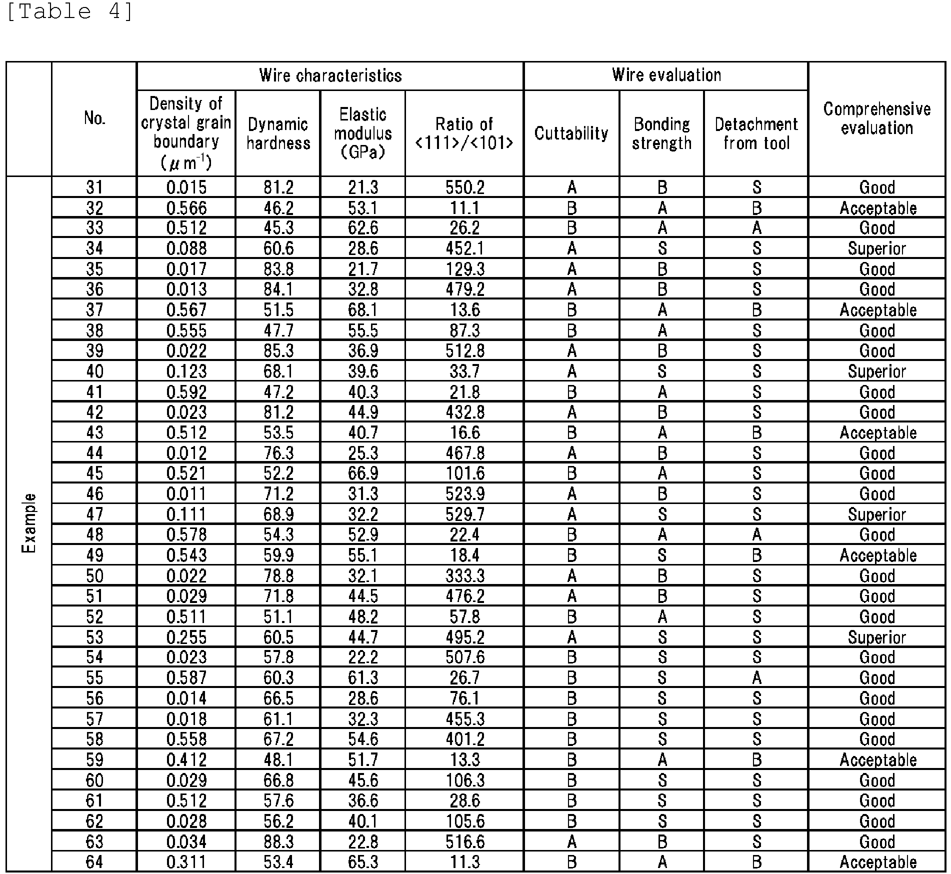

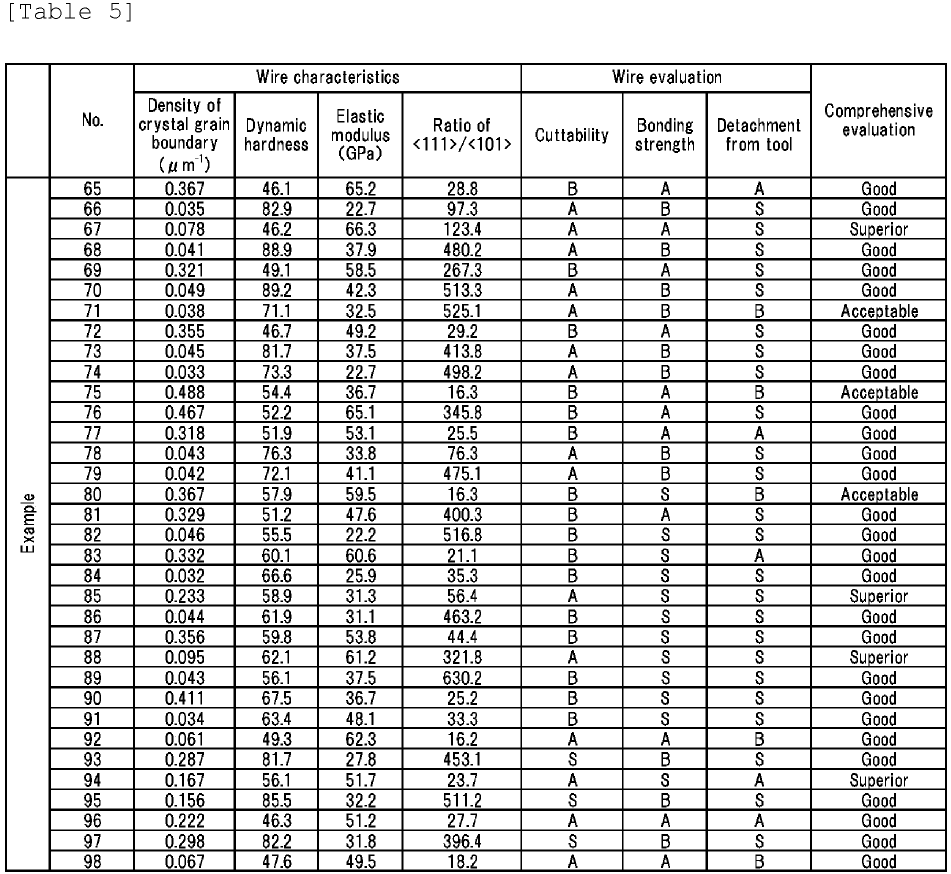

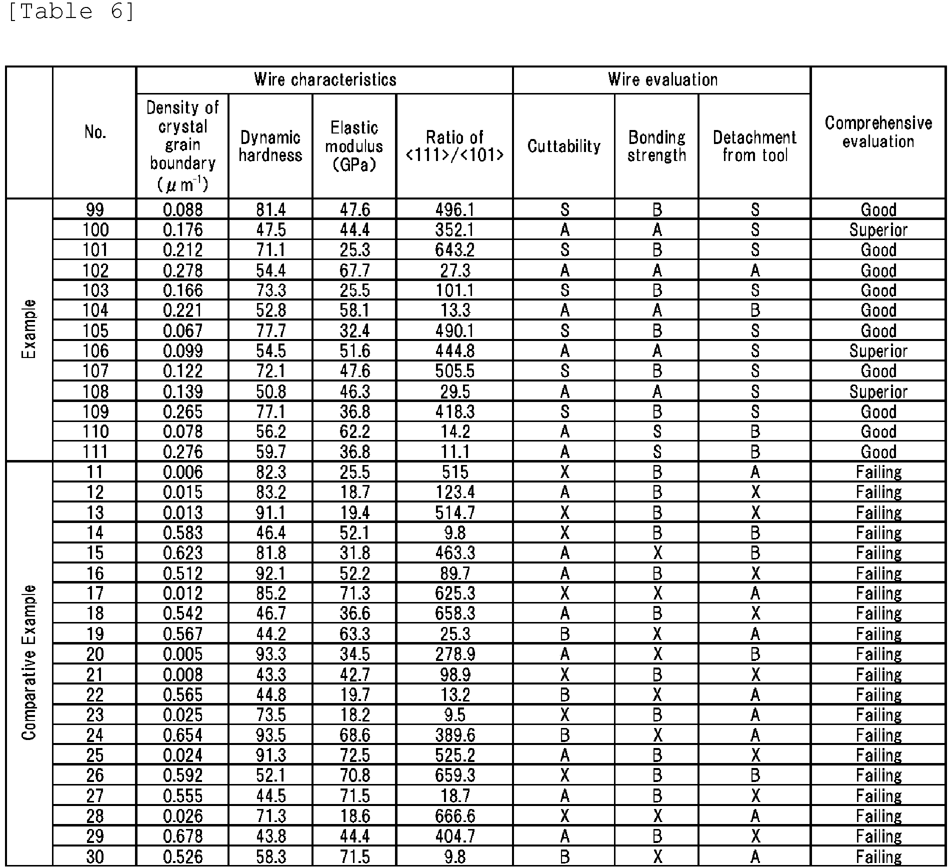

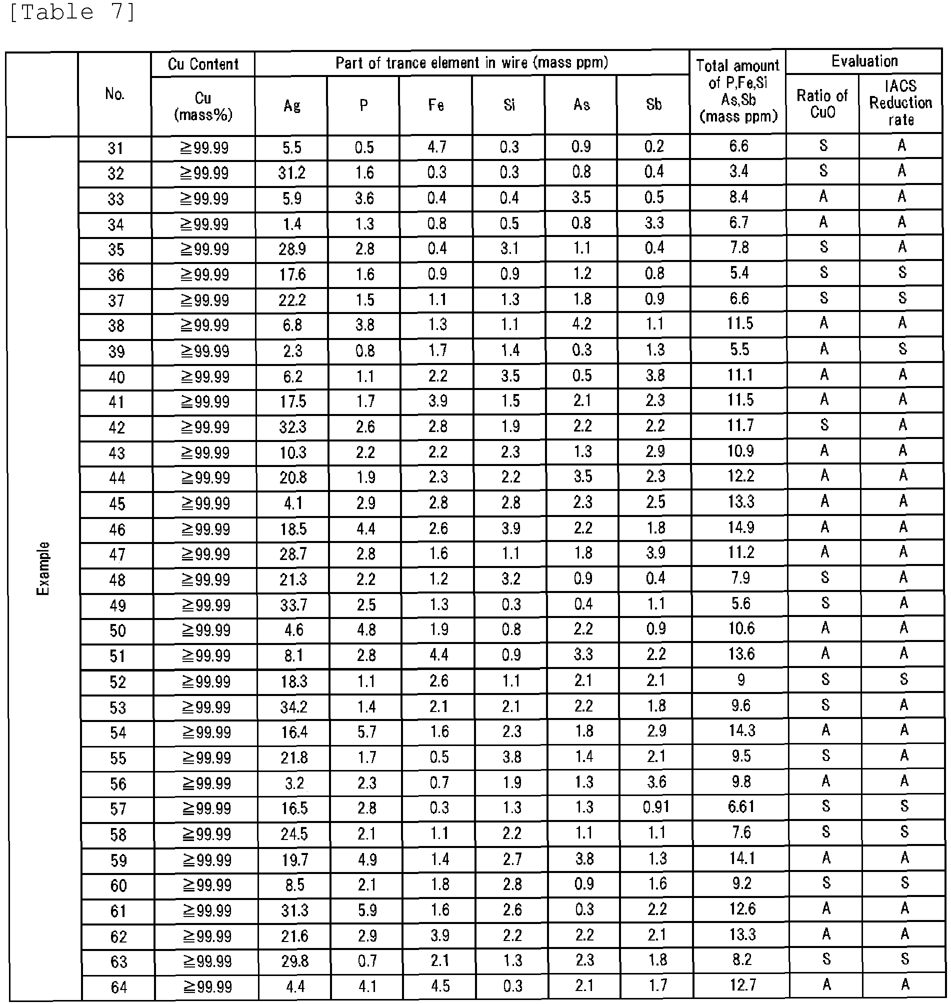

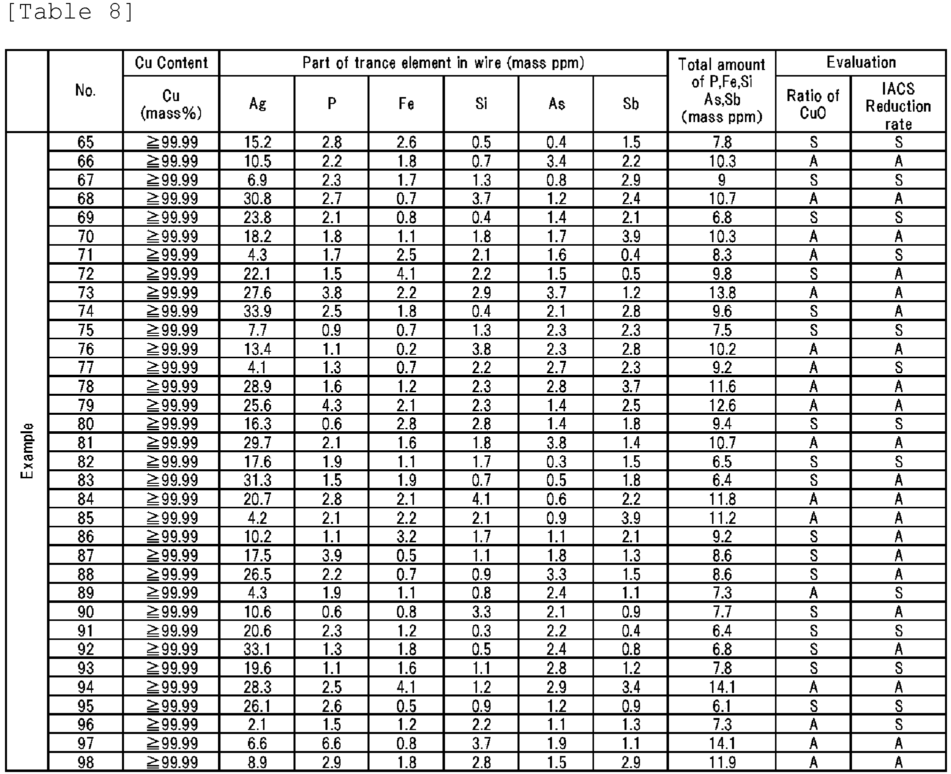

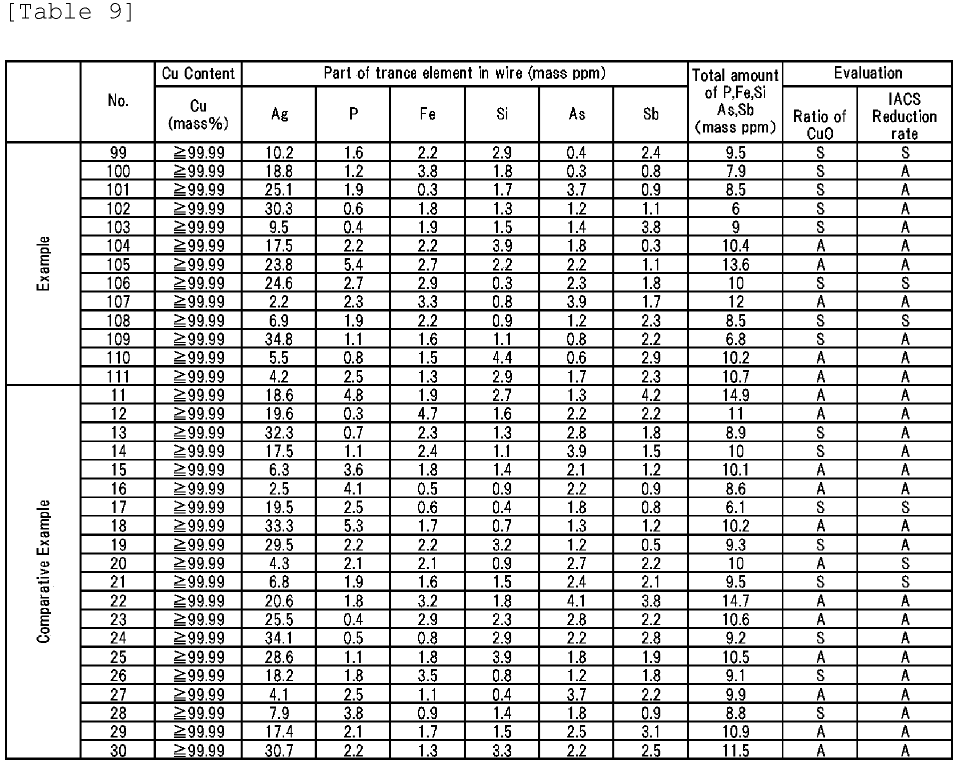

Next, a case where the copper wire of Example was applied to connection between a bus bar of a lithium-ion battery module of an electric vehicle and an electrode of the lithium-ion battery will be described. The lithium-ion battery has several tens of columnar lithium-ion batteries as one unit, and fills the gaps between the lithium-ion batteries adjacent to each other with a gel-like material, thereby avoiding contact between the adjacent batteries and absorbing vibrations during driving of the vehicle.

FIG. 13 is a diagram schematically showing a part of a lithium-ion battery module. The lithium-ion battery module shown in FIG. 13 includes a lithium-ion battery 51, a bus bar 52 on the cathode side, a bus bar 53 on the anode side, and a copper wire 50 that electrically connects the lithium-ion battery 51 and the bus bar 52 on the cathode side. The lithium-ion battery module shown in FIG. 13 further includes another copper wire 50 that electrically connects the lithium-ion battery 51 and the bus bar 53 on the anode side. As the copper wire 50, the copper wire of the embodiment described above is used. In the lithium-ion battery module shown in FIG. 13, an anode and a cathode are disposed on the upper surface and the lower surface of the columnar lithium-ion battery, respectively, and are usually mounted on a vehicle with the anode facing upward and the cathode facing downward.

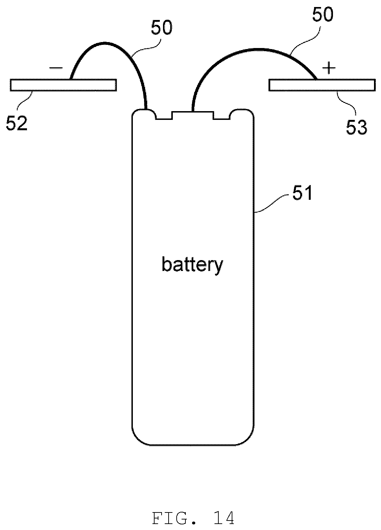

FIG. 14 is a diagram schematically showing a part of a lithium-ion battery module according to another aspect. The lithium-ion battery module shown in FIG. 14 includes a lithium-ion battery 51, a bus bar 52 on the cathode side, a bus bar 53 on the anode side, and a copper wire 50 that electrically connects the lithium-ion battery 51 and the bus bar 52 on the cathode side. The lithium-ion battery module shown in FIG. 14 further includes another copper wire 50 that electrically connects the lithium-ion battery 51 and the bus bar 53 on the anode side. As the copper wire 50, the copper wire of the embodiment described above is used. In the lithium-ion battery module shown in FIG. 14, both the anode and the cathode are disposed at the center and the outer edge of the upper surface of the columnar lithium-ion battery, respectively, and are usually mounted on the vehicle with the anode facing upward.

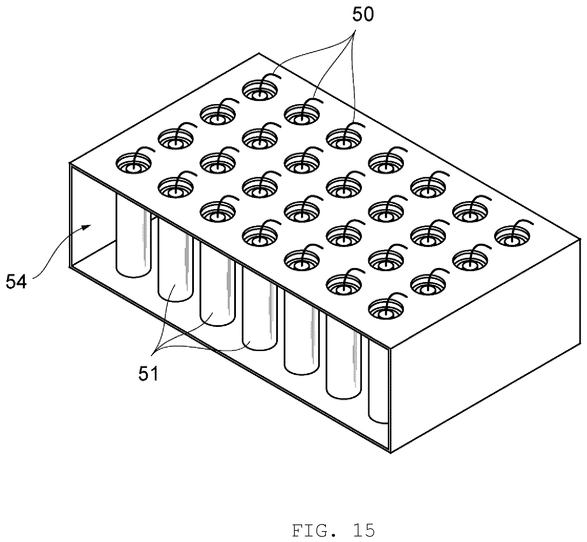

FIG. 15 is a diagram schematically illustrating the entire lithium-ion battery module. As shown in FIG. 15, the lithium-ion battery module is configured by accommodating a plurality of the lithium-ion batteries 51 and filling a gel-like substance 54 between the plurality of lithium-ion batteries 51. Copper wires 50 are connected to the lithium-ion batteries 51.

In the bonding of the bus bar and the copper wire in the lithium-ion battery module and the bonding (wire bonding) of the electrode of the lithium-ion battery and the copper wire, use of a copper wire having good conformability can maintain a good bonding strength. The reason is as follows, for example. Since ultrasonic waves are used in the wire bonding, and since the lithium-ion batteries are not fixed by the gel-like material, the lithium-ion batteries themselves vibrate by ultrasonic waves during the wire bonding. Moreover, there is a difference in height between the electrodes of the lithium-ion batteries and the bus bars. Therefore, in the wire bonding, a bending operation is performed in consideration of vibration of the lithium-ion batteries and a difference in height between the lithium-ion batteries and the bus bars. When a copper wire having a high degree of bending flexibility, or high conformability, is used, it prevents issues such as the wire detaching from the tool during bonding or insufficient bonding strength. This, in turn, helps prevent breakage caused by vibrations in the copper wire while an automobile is travelling.

In order to reduce the size of the electric vehicle, it is required to reduce the size of the battery. According to the copper wire of the embodiment having excellent conformability, it is possible to realize excellent bonding strength even by complicated bending operations in a narrow space. Furthermore, the copper wire of the embodiment having low electrical resistance (high electric conductivity) is less likely to generate heat, and so it is possible to enhance the safety of lithium-ion batteries which are at risk of explosion at high temperatures (e.g., 80°C or higher).

### (Evaluation of bondability and the like of battery electrode and bus bar)

Using the copper wires of Examples 1 to 30 and Comparative Examples 1 to 3, in order to match the actual bonding condition of the lithium-ion battery electrode and the bus bar, using two copper plates, the first bonding was performed on the first copper plate and the second bonding was performed on the second copper plate set at a position lower than the first copper plate by about 20 mm. The wire bonding was performed while the two plates used for the experimental evaluation were disposed not only with height difference, but also at about 45 degrees at a position when projecting the first bonding and the second bonding to a plane. Except for the differences in the positional relationship between the bondings of the first bonding and the second bonding, the cuttability, bonding strength, and detachment from a tool were evaluated with the same bonder BJ935 manufactured by HESSE GmbH as that in the above-described example under the same conditions as those in this example. As a result, all of the samples of Examples 1 to 30 were evaluated as a rating of "B" or higher. In the copper wire of Comparative Example 1, the evaluation of the cuttability was assigned a rating of "X," the evaluation of the bonding strength of the copper wire of Comparative Example 2 was assigned a rating of "X," and the evaluation of the detachment from a tool of the copper wire of Comparative Example 3 was assigned a rating of "X."

From the above-mentioned results, the copper wires of the embodiments were configured to have properties, i.e., the density of crystal grain boundary, the ratio of crystal orientation ratios, the dynamic hardness, and the elastic modulus that were controlled in respective predetermined ranges. As a result, in the wire bonding in the inside of the power semiconductor device or the like, good cuttability could be achieved, and a problem of wire detachment from the wedge bonding portions (lift-off) could be solved. In addition, it was possible to simultaneously solve the problem of the wire detachment from a wedge tool, due to complicated bonding operations via abrupt lateral bending or the like, by the improved conformability of the wire.

In addition, the copper wires of the embodiments are excellent in conformability, has a low formation rate of CuO oxide film, a high bonding strength, and high electric conductivity, and is difficult to generate heat. Thus, the copper wires are very suitable not only for power semiconductor applications but also for bonding between a bus bar of a lithium-ion battery module of an electric vehicle and an electrode of a lithium-ion battery.

The copper wires of the present embodiments can greatly contribute to the development of the automobile industry, the power electronics industry, the electric railway, the electric power industry, and the like, and thus greatly contribute to the reduction of greenhouse gas emissions and the prevention of global warming.

## Claims

1. A copper bonding wire made of a copper alloy having a copper purity of 99.99 mass % or more, the copper bonding wire being configured such that:
a density of crystal grain boundary in a cross section perpendicular to a wire axis of the copper bonding wire is 0.01 µm⁻¹ or more and less than 0.6 µm⁻¹;
among crystal orientations in a wire axis direction in the cross section, a value obtained by dividing an orientation ratio of a crystal orientation <111> having an angular difference of 15° or less relative to the wire axis direction by an orientation ratio of a crystal orientation <101> having an angular difference of 15° or less relative to the wire axis direction is 10 or more and 650 or less;
a dynamic hardness in the cross section is 45 or more and 90 or less; and
an elastic modulus in the cross section is 20 GPa or more and 70 GPa or less.

2. The copper bonding wire according to claim 1, wherein the copper alloy includes, relative to a total amount thereof, silver (Ag) in an amount of 5 mass ppm or more and 30 mass ppm or less, and phosphorus (P), iron (Fe), silicon (Si), arsenic (As), and antimony (Sb) each in an amount of 0 mass ppm or more and 3 mass ppm or less with a total amount being 15 mass ppm or less.

3. The copper bonding wire according to claim 1 or 2, wherein a wire diameter thereof is 40 µm or more and 700 µm or less.

4. A method for manufacturing a copper bonding wire made of a copper alloy having a copper purity of 99.99 mass % or more, the method comprising:
a step of preparing a copper wire made of a copper alloy having a copper purity of 99.99 mass % or more;
a step of drawing the copper wire; and
a step of performing a final heat treatment on the drawn copper wire to produce the copper bonding wire, the copper bonding wire being configured such that:
a density of crystal grain boundary in a cross section perpendicular to a wire axis of the copper bonding wire is 0.01 µm⁻¹ or more and less than 0.6 µm⁻¹;
among crystal orientations in a wire axis direction in the cross section, a value obtained by dividing an orientation ratio of a crystal orientation <111> having an angular difference of 15° or less relative to the wire axis direction by an orientation ratio of a crystal orientation <101> having an angular difference of 15° or less relative to the wire axis direction is 10 or more and 650 or less;
a dynamic hardness in the cross section is 45 or more and 90 or less; and
an elastic modulus in the cross section is 20 GPa or more and 70 GPa or less.

5. A power semiconductor device comprising at least one substrate, at least one semiconductor element on the substrate, an electrode on a surface of the semiconductor element, a semiconductor element upper substrate on the semiconductor element, at least one circuit pattern on the substrate, and
a copper wire connecting one or more selected from the group consisting of the electrodes on the surface of the semiconductor element, the electrode on the surface of the semiconductor element and an external electrode, the electrode on the surface of the semiconductor element and one of the circuit patterns, the electrode on the surface of the semiconductor element and a terminal, two adjacent circuit patterns among the circuit patterns, one of the circuit patterns and the terminal, the substrates, and the semiconductor element upper substrate and the circuit pattern, wherein:
the copper wire is a copper bonding wire made of a copper alloy having a copper purity of 99.99 mass % or more; and
the copper bonding wire is configured such that:
a density of crystal grain boundary in a cross section perpendicular to a wire axis of the copper bonding wire is 0.01 µm⁻¹ or more and less than 0.6 µm⁻¹;
among crystal orientations in a wire axis direction in the cross section, a value obtained by dividing an orientation ratio of a crystal orientation <111> having an angular difference of 15° or less relative to the wire axis direction by an orientation ratio of a crystal orientation <101> having an angular difference of 15° or less relative to the wire axis direction is 10 or more and 650 or less;
a dynamic hardness in the cross section is 45 or more and 90 or less; and
an elastic modulus in the cross section of the copper bonding wire is 20 GPa or more and 70 GPa or less.
